# EUROPEAN PATENT APPLICATION

(11) **EP 3 851 553 A1**
(43) Date of publication of application: **21.07.2021**
(21) Application number: 19859170.3
(22) Date of filing: 10.09.2019
(51) Int. Cl.: C23C 14/02, B32B 15/09

(54) **METAL-COATED MOLDED RESIN ARTICLES AND PRODUCTION METHOD THEREFOR**

(30) Priority: 11.09.2018 JP 2018169807
(71) Applicant: Mitsubishi Engineering-Plastics Corporation, Tokyo 105-0021 (JP)
(72) Inventor: SARUWATARI, Tetsuya, Kyoto-shi, Kyoto 604-8511 (JP); YOSHIOKA, Naoki, Kyoto-shi, Kyoto 604-8511 (JP); YAMANAKA, Yasushi, Hiratsuka-shi, Kanagawa 254-0016 (JP)
(74) Representative: Hoffmann Eitle
(86) International application number: PCT/JP2019/035509
(87) International publication number: WO 2020/054705

(57) **Abstract**

A metal film-coated molded resin article comprising: a molded article formed of a polybutylene terephthalate-based resin composition and/or a polycarbonate-based resin composition; and a metal film disposed on a surface of the molded article, wherein the resin composition(s) contain(s) a reactive compound and/or a resin having a reactive functional group. A metal film-coated molded resin article comprising: a molded article formed of a polybutylene terephthalate-based resin composition; and a metal film disposed on a surface of the molded article, wherein the peel strength of the metal film that is measured according to an adhesion test method described in appendix 1 (specifications) of JIS H8630:2006 is 9.0 N/cm or more. Provided is a metal film-coated molded resin article in which a metal film excellent in adhesion is formed on the surface of a molded resin article such as a molded polybutylene terephthalate based-resin article and/or a molded polycarbonate-based resin article using a dry process instead of electroless plating.

## Description

### Technical Field

The present invention relates to a metal film-coated molded resin article in which a metal film is formed on the surface of a molded resin article formed of a polybutylene terephthalate-based resin composition and/or a polycarbonate-based resin composition and to a method for producing the metal film-coated molded resin article.

In the present invention, "the metal film" not only refers to a film composed of a single metal but also is intended to encompass metal films including alloy films formed of two or more metals in a broad sense.

With the recent rapid development of the IT society, the processing speed of electronic devices is increasing, and the operating frequency of ICs such as LSIs and microprocessors is increasing. For example, in the telecommunications field, high-speed communications networks using optical fibers are used. Electromagnetic waves with a frequency of 2 GHz are used for next generation multimedia mobile communications, and electromagnetic waves with a frequency of 5.8 GHz are used for an ETS system (electronic toll collection system) in the field of ITS (Intelligent Transport System). Moreover, electromagnetic waves with a frequency of 76 GHz are used for an automobile-mounted radar for an advanced cruise-assist highway system (AHS) that measures the distance between vehicles and informs the driver of the distance. It is expected that the range of use of high frequency electromagnetic waves will be further expanded in the future. As the frequency of electromagnetic waves increases, noise is more likely to be emitted. Moreover, as electronic devices are reduced in size and increased in density, the noise environment inside the electronic devices deteriorates, and this causes malfunctions of the devices. One problem associated with the present usage of high-frequency electromagnetic waves is that such electromagnetic waves may adversely affect humans.

Metal materials have generally been used for conventional electromagnetic wave shieling materials (electromagnetic wave blocking materials) for shielding electromagnetic waves. However, in recent years, electromagnetic wave shieling materials produced by forming a metal film on the surface of a molded resin article by electroplating are widely used instead of the high-specific gravity metal materials.

When a metal plating film is formed on the surface of a molded resin article, electroless plating treatment is performed before electroplating treatment.

Specifically, since the resin is a nonconductive material, the resin is subjected to pretreatment, i.e., etched with hexavalent chromic acid, to form irregularities on the surface of the molded resin article, and its physical adhesion to the metal plating film is thereby improved. Alternatively, the electroless plating treatment is performed after a palladium catalyst is applied to form a catalytically activated seed layer.

However, the environmental load of hexavalent chromic acid used for the etching treatment is large. Therefore, hexavalent chromic acid is subject to regulation, and its use will be restricted in 2023. Moreover, palladium used for the seed layer is a rare metal and causes an increase in cost.

Moreover, these processes require many treatment baths for washing with water, neutralization, etc., and a large number of facilities are required. Another issue is that waste water treatment etc. must be performed. Therefore, these processes are not preferred from the viewpoint of the footprint of the facilities, production cost, productivity, etc. It is therefore desired to form a metal coating used as a base for an electroplating film by a dry process instead of electroless plating.

In view of the above circumstances, the inventors of the present application have filed a patent application relating to a method for forming a metal film excellent in adhesion on the surface of an insulating material such as a resin using a dry process (Japanese Patent Application No. 2018-097358). In this method, plasma CVD using a hollow cathode electrode and sputtering are used to form a seed layer on the surface of the insulating material such as a resin, and then electroplating is performed.

A polybutylene terephthalate-based resin used in the present invention is excellent in mechanical properties, electric properties, heat resistance, etc. and is an engineering plastic widely used in the fields of electrical equipment components, mechanical components, etc. in recent years. To use the polybutylene terephthalate-based resin for electromagnetic wave shieling materials etc., there is a demand for development of a method for forming a metal film on the surface of a molded polybutylene terephthalate-based resin article by a dry process.

A polycarbonate-based resin is excellent in transparency, heat resistance, mechanical strength, shock resistance, etc. and is an engineering plastic widely used in the fields of electrical equipment components, mechanical components, automobile components, etc. in recent years. To use the polycarbonate resin for electromagnetic wave shieling materials etc., there is a demand for development of a method for forming a metal film on the surface of a molded polycarbonate-based resin article by a dry process. Moreover, there is a demand for development of a method for forming a metal film on the surface of a transparent molded polycarbonate-based resin article by a dry process.

### Citation List

### Patent Literature

PTL 1: Japanese Patent Application No. 2018-097358

### Summary of Invention

### Technical Problem

An object of the present invention is to provide a metal film-coated molded resin article in which a metal film excellent in adhesion is formed on the surface of a molded article formed of a polybutylene terephthalate resin-based composition and/or a polycarbonate-based resin composition by a dry process instead of electroless plating and to provide a method for producing the metal film-coated molded resin article.

### Solution to Problem

A metal film-coated molded resin article according to a first embodiment of the present invention comprises: a molded article formed of a polybutylene terephthalate-based resin composition and/or a polycarbonate-based resin composition; and a metal film disposed on a surface of the molded article, wherein the resin composition(s) contain(s) a reactive compound and/or a resin having a reactive functional group.

A metal film-coated molded resin article according to a second embodiment of the present invention comprises: a molded article formed of a polybutylene terephthalate-based resin composition; and a metal film disposed on a surface of the molded article, wherein the peel strength of the metal film that is measured according to an adhesion test method described in appendix 1 (specifications) of JIS H8630:2006 is 9.0 N/cm or more.

Preferably, the polybutylene terephthalate-based resin composition used in the second aspect contains a reactive compound and/or a resin having a reactive functional group.

The reactive compound and/or the resin having a reactive compound resin used in the present invention is preferably a compound having an amido group and/or a resin having an amido group, and the resin containing an amido group is preferably a polyamide resin.

A plating film-coated molded article of the present invention includes: the metal film-coated molded resin article of the present invention; and a plating layer disposed on the metal film.

A vehicle-mounted component of the present invention includes the plating film-coated molded article of the present invention.

An electrical component of the present invention includes the plating film-coated molded article of the present invention.

A resin composition of the present invention is used to produce a metal film-coated molded resin article including a metal film formed on a surface of a molded polybutylene terephthalate-based resin article and/or a surface of a molded polycarbonate-based resin article using a dry process, and the resin composition comprises a reactive compound and/or a resin having a reactive functional group.

A method for producing a metal film-coated molded resin article according to the present invention comprises depositing the metal film on a surface of a molded polybutylene terephthalate resin-based article and/or a surface of a molded polycarbonate-based resin article using a dry process.

In the method for producing the metal film-coated molded resin article of the present invention, it is preferable that, after the surface of the molded polybutylene terephthalate resin-based article and/or the surface of the molded polycarbonate-based resin article is subjected to plasma treatment in a vacuum atmosphere, the metal film is deposited on the plasma-treated surface(s) by spattering.

A method for producing the plating film-coated molded article of the present invention includes forming a plating layer on the metal film of the metal film-coated molded resin article produced by the metal film-coated molded resin article production method of the present invention. Advantageous Effects of Invention

The present invention can provide a metal film-coated molded resin article in which a metal film excellent in adhesion is formed on the surface of a molded resin article such as a molded polybutylene terephthalate based-resin article and/or a molded polycarbonate-based resin article using a dry process instead of electroless plating. Description of Embodiments

Embodiments of the present invention will next be described in detail.

### [Metal film-coated molded resin article]

The metal film-coated molded resin article according to the first embodiment of the present invention comprises: a molded article formed of a polybutylene terephthalate-based resin composition and/or a polycarbonate-based resin composition; and a metal film disposed on a surface of the molded article, wherein the resin composition(s) contain(s) a reactive compound and/or a resin having a reactive functional group.

The metal film-coated molded resin article according to the second embodiment of the present invention comprises: a molded article formed of a polybutylene terephthalate-based resin composition; and a metal film disposed on a surface of the molded article, wherein the peel strength of the metal film that is measured according to an adhesion test method described in appendix 1 (specifications) of JIS H8630:2006 is 9.0 N/cm or more.

The metal film-coated molded resin article of the present invention can be produced by a metal film-coated molded resin article production method of the present invention including depositing the metal film on the surface of the molded polybutylene terephthalate resin-based article and/or the surface of the molded polycarbonate-based resin article using a dry process.

The metal film-coated molded resin article production method is preferably a method including subjecting the surface of the molded polybutylene terephthalate resin-based article and/or the molded polycarbonate-based resin article to plasma treatment in a vacuum atmosphere and then depositing the metal film on the plasma-treated surface by sputtering. Before the plasma treatment, heat treatment may be performed.

In the following description, the polybutylene terephthalate-based resin composition and the polycarbonate-based resin composition used in the present invention may be referred to as "the polybutylene terephthalate-based resin composition of the present invention" and "the polycarbonate-based resin composition of the present invention," respectively, and may be collectively referred to as "the resin composition of the present invention."

A molded article formed of the resin composition of the present invention may be referred to as "the molded article of the present invention."

The chemical composition of the resin composition of the present invention, a production method therefor, and a molding method will be described later.

The metal film-coated molded resin article of the present invention will be described in accordance with the method for producing the metal film-coated molded resin article of the present invention.

### [Dry process]

Examples of the method for forming the metal film on the surface of the molded article of the present invention using the dry process include a method using a combination of plasma CVD and sputtering described later, PVD, thermal CVD, ECR plasma CVD, optical CVD, MO CVD (Metalorganic Chemical Vapor Deposition), a diode sputtering method, a magnetron sputtering method, sputtering using a DC (direct current) RF (radio frequency) power source, a dual magnetron method, reactive sputtering, facing-target ion beam sputtering, and ECR (Electron Cyclotron Resonance) sputtering. Only one type of dry process may be used to deposit the metal film, or a combination of two or more may be used to deposit the metal film.

Among these dry processes, a method in which a plasma step and a sputtering step are performed to deposit the metal film is particularly preferable in the present invention because the metal film deposited has excellent adhesion.

The method for depositing the metal film through the plasma step and the sputtering step will be described.

### [Heating step]

In the present invention, before the plasma step described later, a heating step of heating the molded article of the present invention may be performed. By performing the heating step, volatilization of water and gas from the molded article of the present invention in the plasma step can be prevented, and the metal film formed can have better adhesion.

The heating temperature in the heating step may be a temperature which is lower than the softening temperature of the resin forming the molded article of the present invention and at which water and gas can be released from the molded article of the present invention to prevent volatilization of these components in the plasma step. For a molded article formed of the resin composition of the present invention, the heating temperature is generally 80 to 200°C and particularly preferably 80 to 120°C. The heating time varies depending on the heating temperature. If the heating time is excessively short, the effect of the heating step cannot be obtained sufficiently. If the heating time is excessively long, the productivity deteriorates. Therefore, the heating time is preferably about 1 to about 10 hours and particularly preferably about 1 to about 3 hours.

No particular limitation is imposed on the atmosphere and the pressure in the heating step. The heating step may be performed at atmospheric pressure. However, a reduced pressure condition of 133 Pa or lower in a N₂ atmosphere or a vacuum condition of 10⁻¹ Pa or lower may be used. Under these conditions, the same effects as those of heating under normal pressure may be obtained even when the heating temperature is lowered and the heating time is shortened.

It is preferable that the plasma step is started immediately after the heating step, e.g., within 0 to 30 minutes after the heating step, in order to prevent volatile components such as moisture from again being absorbed by the molded article of the present invention.

### [Plasma step]

The plasma step is an activation processing step of generating reactive functional groups on the surface of the molded article of the present invention to increase bondability to metal atoms to thereby improve adhesion to the metal film to be deposited by sputtering.

The plasma step is performed preferably using a hollow cathode electrode under vacuum conditions. In particular, it is preferable to perform the plasma step using an apparatus described in Japanese Patent Application No. 2018-097358 described above under vacuum conditions and then perform the sputtering step described later continuously.

To generate the reactive functional groups more efficiently on the surface of the molded article of the present invention using the plasma treatment, it is preferable that the resin composition of the present invention contains a reactive compound and/or a resin having a reactive functional group, as described later.

With the plasma treatment using the hollow cathode electrode, radical discharge can be performed at a high electron density (of the order of 10¹¹ cm⁻³), so that temperature damage to the treatment target at high temperature can be reduced. Moreover, plasma CVD using O₂ that requires high energy for dissociation can be performed. Therefore, discharge can be stabilized to increase the effect of the O₂ treatment, and the reactive functional groups are efficiently formed on the surface of the molded article of the present invention, so that the adhesion of the metal film to be formed by the subsequent sputtering can be further increased.

In particular, by performing the plasma step and the sputtering step described later continuously in a vacuum atmosphere, the molded article of the present invention can be subjected to sputtering deposition after the plasma treatment without exposure to air, so that degradation etc. of the plasma-treated surface of the molded article of the present invention can be prevented to stabilize the treated surface.

The plasma CVD treatment may be performed as follows. Preferably, the molded article of the present invention and a plasma generation source including the hollow cathode electrode and a counter electrode integrated with a gap therebetween are disposed in a pressure-tight chamber. The molded article of the present invention and the plasma generation source are positioned such that the surface of the molded article of the present invention that is to be plasma-treated faces the hollow cathode electrode and that the molded article of the present invention is spaced apart from the hollow cathode electrode. Then the pressure inside the chamber is reduced, and a reaction gas is supplied between the hollow cathode electrode and the counter electrode of the plasma generation source. Then a voltage is applied to the plasma generation source.

The reason that the temperature damage to the molded article of the present invention can be reduced when the above procedure is used is as follows.

Specifically, the plasma has high temperature just after emitted from the plasma generation source. As the plasma drifts in the chamber, the plasma collides with the reaction gas present in the chamber and loses its thermal energy. Therefore, when the plasma reaches the molded article of the present invention that is a processing target spaced apart from the plasma generation source, the temperature of the plasma has been reduced.

Part of the plasma has been changed from its plasma state (charged state) to an activated state (radical state) because of collision with the reaction gas etc. Therefore, the molded article of the present invention is exposed not only to the plasma of the reaction gas but also to the reaction gas in the activated state (radical state). In the present description, the reaction gas in the plasma state and the reaction gas in the activated state (radical state) are referred to as highly reactive reaction gases. The activation of the surface of the molded article of the present invention, which is the treatment target, using the reaction gas in the plasma state and the reaction gas in the radical state is referred to as the plasma treatment.

As described above, the plasma reduced in temperature reaches the molded article of the present invention used as the treatment target, and the reaction gas in the radical state also reaches the molded article. This effect is obtained because the molded article of the present invention is disposed at a position spaced apart from the hollow cathode electrode on the side opposite to the counter electrode. In other words, the plasma generation source is designed such that the molded article of the present invention and the counter electrode are arranged with the hollow cathode electrode therebetween such that the distance between the hollow cathode electrode and the molded article of the present invention is longer than the distance between the hollow cathode electrode and the counter electrode.

When the distance between the plasma generation source and the molded article of the present invention used as the treatment target is large as described above, it is feared that the concentration of the highly reactive reaction gases reaching the molded article of the present invention may be low.

However, since the pressure inside the chamber with the plasma generation source and the molded article of the present invention placed therein is reduced to form a vacuum atmosphere, the plasma generated from the plasma generation source is prevented from colliding with gas molecules (reaction gas molecules) unnecessarily, and a reduction in the concentration of the highly reactive reaction gases can be prevented.

In the present invention, it is preferable to perform the plasma treatment in the following specific procedure under the following specific conditions.

First, the reaction gas at a first pressure P1 is supplied to the plasma generation source, and electric power with a first output E1 is applied to form a first plasma state. Then the reaction gas at a second pressure P2 higher than the first pressure P1 is supplied to the plasma generation source, and electric power with a second output E2 lower than the electric power with the first output E1 is applied to form a second plasma state. Specifically, when the pressure of the reaction gas in the plasma generation source is high at the start of the plasma treatment, discharge between the hollow cathode electrode and the counter electrode is unlikely to occur, and plasma cannot be generated. Therefore, at the start of the plasma treatment, the pressure of the reaction gas in the plasma generation source is set to the relatively low first pressure P1 to allow discharge to occur to thereby generate plasma. Once the plasma has been generated, the charged plasma and electrons allow the discharge to easily continue, so that the pressure of the reaction gas in the plasma generation source is set to the second pressure P2 higher than the first pressure P1. In this manner, high-concentration plasma can be generated from the plasma generation source, and the molded article of the present invention used as the treatment target can be exposed to a larger amount of the highly reactive reaction gases, so that the treatment ability can be further improved.

The first pressure P1 is preferably a pressure of, for example, from 0.5 Pa to 3 Pa inclusive. If the first pressure P1 is lower than 0.5 Pa, the initial concentration of the plasma is low, so that it is difficult to maintain the discharge stably. If the first pressure P1 is higher than 3 Pa, it is difficult to perform discharge.

The second pressure P2 is preferably a pressure of, for example, from 10 Pa to 50 Pa inclusive. If the second pressure P2 is lower than 10 Pa, the concentration of the plasma is low, so that it is difficult to obtain a high treatment ability. If the second pressure P2 is higher than 50 Pa, it is difficult to maintain the discharge.

The first output E1, which is the electric power applied to the hollow cathode electrode to form the first plasma state, is preferably from 2 W/cm² to 5 W/cm² inclusive per unit area of the hollow cathode electrode. If the first output E1 is less than 2 W/cm², it is difficult to generate discharge in the plasma generation source to form plasma. If the first output E1 is higher than 5 W/cm², abnormal discharge may occur in the plasma generation source.

The second output E2, which is the electric power applied to the hollow cathode electrode to form the second plasma state, is preferably from 0.5 W/cm² to 2 W/cm² inclusive per unit area of the hollow cathode electrode. If the second output E2 is less than 0.5 W/cm², it is difficult to maintain the discharge in the plasma generation source and the formation of the plasma. If the second output E2 is higher than 2 W/cm², abnormal discharge may occur in the plasma generation source.

In the above treatment conditions, the duration t1 of the first plasma state is preferably 0 to 5 seconds, and the duration t2 of the second plasma state is preferably at least 10 times the duration t1 of the first plasma state, e.g., 10 to 100 times the duration t1. The concentration of the highly reactive reaction gases generated is higher in the second plasma state than in the first plasma state. Therefore, by increasing the duration t2 of the second plasma state as described above, the treatment can be performed more efficiently.

In the above plasma conditions, the distance from the hollow cathode electrode to the molded article of the present invention is preferably from 100 mm to 250 mm inclusive. If this distance is shorter than 100 mm, the temperature of the molded article of the present invention may increase. If the distance is longer than 250 mm, the plasma concentration decreases, so that it is difficult to obtain a high treatment ability.

Preferably, the plasma treatment in the present invention is performed as plasma treatment using not only the reaction gas in the plasma state but also the reaction gas in the activated state (radical state). The reaction gas used is preferably oxygen (O₂) that exhibits high reactivity in the radical state, because the efficiency of the plasma treatment can be further improved. The reaction gas may be nitrogen. However, in terms of the efficiency of the plasma treatment, it is preferable to use oxygen or a gas mixture of oxygen and an inert gas such as argon. When a gas mixture of oxygen and an inert gas is used, the concentration of oxygen in the gas mixture is preferably 99.9% or more.

### [Sputtering step]

Next, sputtering is used to deposit the metal film on the plasma-treated surface of the surface-activated molded article of the present invention subjected to the plasma step.

As described above, it is important, in terms of depositing a metal film with higher adhesion, that the sputtering step be performed such that the molded article of the present invention subjected to the plasma treatment is not exposed to air.

The sputtering step can be performed according to a routine method. Specifically, the plasma-treated molded article of the present invention is placed inside a vacuum chamber so as to face a sputtering electrode including a target material and an electrode portion. The electric power applied to the sputtering electrode is 10 kW or higher and particularly preferably as high as 30 kW or more.

Generally, in a sputtering apparatus, a film is deposited after the pressure inside the sputtering apparatus is reduced to about 0.1 Pa in order to increase the purity of the deposited film. This is because, if the pressure inside the sputtering apparatus is higher than 0.1 Pa, it is difficult to remove impurities such as water remaining in the sputtering apparatus or released from the treatment target, so that the impurities are mixed into the film, causing a reduction in the quality of the film. However, in particular, when the treatment target is a resin, the amount of impurities released from the treatment target is large, and the impurities are continuously released for a long time. Therefore, unlike the film deposition in the conventional sputtering apparatus, it is difficult to perform film deposition under a reduced pressure of about 0.1 Pa.

Accordingly, in the present invention, in order to allow a high performance film to be deposited even when the amount of impurities released from the molded article of the present invention used as the treatment target is large, it is preferable that a sputtering power source capable of supplying an electric power of 10 kW or higher and more preferably 30 kW or higher, e.g., 10 to 40 kW, to the sputtering electrode is used to deposit the film under high electric power conditions.

When the electric power supplied to the sputtering electrode is high, the amount of metal atoms such as copper atoms released from the target material is larger than that when normal electric power is supplied, and the kinetic energy of the metal atoms also increases. Therefore, the concentration of the impurities in the treatment system relative to the concentration of the metal atoms decreases, so that the purity of the film deposited on the treatment target increases. Moreover, since the kinetic energy of metal atoms impinging on the treatment target is large, molecules forming the treatment target are bonded to the metal atoms stably, so that a film with high adhesion to the treatment target can be deposited.

The metal atoms released from the target material travel in straight lines within the chamber but collide with inert gas in the chamber, so that their traveling directions are diffused (scattered). In conventional sputtering apparatuses, the kinetic energy of metal atoms is low. Therefore, metal atoms that have collided with inert gas, been scattered, and reduced in kinetic energy cannot adhere to the treatment target with sufficient strength. When the treatment target has projections and depressions, the side surfaces of the projections and depressions are irradiated only with scattered metal atoms whose kinetic energy has been reduced, so that it is difficult to deposit a uniform film on the treatment target having the projections and depressions. However, when sputtering is performed under the high electric power conditions as described above, the kinetic energy of metal atoms released from the target material is high, and the metal atoms have sufficient kinematic energy even after scattering by the inert gas. Therefore, even when a treatment target having projections and depressions is used, the treatment target is irradiated with scattered metal atoms traveling in various directions and having large kinetic energy, and a uniform film can be deposited on the treatment target.

To obtain the above effect, the pressure inside the chamber during sputtering is preferably about 0.5 Pa to about 5 Pa. When the pressure inside the chamber during sputtering is 0.5 Pa or higher, metal atoms released from the target material can be scattered sufficiently. When the pressure is 5 Pa or less, the concentration of impurities in the chamber can be reduced, and the quality of the film can be maintained.

### [Metal film]

Examples of the metal film formed on the molded article of the present invention include films formed of metals such as copper, aluminum, chromium, and nickel and alloys containing two or more of these metals.

The thickness of the metal film is preferably about 100 to about 500 nm. When the film thickness is equal to or more than the above lower limit, the electric resistance of the film is low, and the function as the seed layer can be obtained sufficiently. When the film thickness in equal to or lower than the above upper limit, the time required for film deposition is not unnecessarily long, and the cost of production can be reduced.

### [Peel strength of metal film]

The metal film in the metal film-coated molded resin article of the present invention has high adhesion strength, and its peel strength measured according to an adhesion test method described in appendix 1 (specifications) of JIS H8630:2006 is preferably 9.0 N/cm or more. The peel strength is more preferably 10.0 N/cm or more and still more preferably 13.0 N/cm or more.

Specifically, the peel strength of the metal film is measured by a method described in Examples.

### [Resin composition of present invention]

The resin composition of the present invention will next be described.

### [Reactive compound and/or resin having reactive functional group]

The resin composition of the present invention contains a thermoplastic resin such as a polybutylene terephthalate resin and/or a polycarbonate resin as a main resin component, as described later. To obtain a high plasma treatment effect by the plasma treatment described above, it is preferable to contain a reactive compound and/or a resin having a reactive functional group (hereinafter may be collectively referred to as a "reactive component").

The reactive compound and/or the resin having the reactive functional group is a compound reactive with a resin component such as the polybutylene terephthalate resin and/or the polycarbonate resin, and no particular limitation is imposed on the type of reactive compound and/or the type of resin having the reactive functional group. A preferred compound is appropriately selected and used according to the properties etc. required for the molded resin article to be obtained.

No particular limitation is imposed on the reactive component, and the reactive compound is preferably at least one selected from the group consisting of carbodiimide compounds, epoxy compounds, compounds having an oxazoline group and/or an oxazoline ring, compounds having an oxazine group and/or an oxazine ring, compounds including carboxylic acid, and compounds having an amido group and/or resins having any of these reactive functional groups. Particularly preferably, the reactive compound is an epoxy compound and/or a resin having an epoxy group or a compound having an amido group and/or a polyamide resin.

No particular limitation is imposed on the portion of a resin component contained in the resin composition of the present invention with which portion the reactive compound and/or the resin having the reactive functional group reacts. In the case of the polybutylene terephthalate resin, the reactive compound and/or the resin having the reactive functional group may react with a carboxyl group or a hydroxy group at an end of the polybutylene terephthalate resin or may react with an ester bond in the polymer chain of the polybutylene terephthalate resin. In the case of the polycarbonate resin, the reactive compound and/or the resin having the reactive functional group may react with a hydroxy group or a tert-butylphenol group at an end of the polycarbonate resin.

Irrespective of the portion of the resin component with which the reactive compound and/or the resin having the reactive functional group reacts, the resin component and the reaction product of the resin component and the reactive component are exposed to high temperature in order to allow the reaction to proceed, so that thermal decomposition of the original resin component and thermal decomposition of the resin component-derived portion of the reaction product of the resin component and the reactive component occur. Therefore, the present invention can be applied to any reaction. From this point of view, the deposition of the metal film on the molded article of the present invention is not limited to the deposition on the molded article formed of the polybutylene terephthalate resin composition and/or the polycarbonate-based resin composition but is applicable to deposition on a molded article formed of another thermoplastic resin composition. In the present invention, the resin component and the reactive component may partially react in their molten state. For example, when a reactive component reactable with a terminal carboxyl group or a terminal hydroxy group in the polybutylene terephthalate resin or a reactive component reactable with an ester bond in the polymer chain of the polybutylene terephthalate resin is used, the resin component and the reactive component partially react in their molten state smoothly. This is also the case for the polycarbonate resin.

Examples of the reactive component reactable with a terminal carboxyl group or a terminal hydroxy group in the polybutylene terephthalate resin and with a terminal hydroxy group or a terminal tert-butylphenol group in the polycarbonate resin include compounds and resins having any of a hydroxy group, a carboxylic anhydride group, an epoxy group, an isocyanate group, a carbodiimide group, an oxazoline group, a glycidyl group, an amino group, an imino group, a cyano group, an azo group, a thiol group, a sulfo group, a nitro group, an alkoxy group, an ether bond, an ester bond, an amide bond, a urethane bond, etc.

For the purpose of the invention that the plasma treatment effect is increased, the reactive functional group is preferably an amido group, an epoxy group, an imido group, a carbonyl group, or an alcohol group and particularly preferably an amido group.

With a resin composition containing a compound or a resin having any of the above reactive functional groups, a large number of reactive functional groups that can improve bondability with metal atoms can be generated on the surface of the molded article of the present invention using the plasma treatment described above. The surface is thereby highly activated, and the adhesion of the sputtered metal film can be increased.

### <Compound/resin having amido group>

Examples of the compound having an amido group include (meth)acrylamide, N-methylmethacrylamide, methylolated acrylamide, methylolated methacrylamide, ureidovinyl ether, β-ureidoisobutylvinyl ether, and ureidoethyl acrylate.

The resin having an amido group is preferably a polyamide resin described later as a resin other than the polybutylene terephthalate resin and/or the polycarbonate resin contained as a resin (A).

Only one compound having an amido group and/or only one resin having an amido group may be used, or a mixture of two or more may be used.

When the resin composition of the present invention contains a polyamide resin, it is preferable that the polyamide resin has a melting point close to the melting points of the polybutylene terephthalate resin and/or the polycarbonate resin in the resin composition of the present invention or has a melting point equal to or lower than the melting points of the polybutylene terephthalate resin and/or the polycarbonate resin.

### <Compound/resin having epoxy group>

Examples of the compound and resin having an epoxy group include epoxy compounds described below (hereinafter, an epoxy compound used as the reactive component may be referred to as an "epoxy compound (B)"). Other examples include a brominated epoxy compound used suitably as a flame retardant (D) described later and an epoxy resin used as a surface treatment agent for a reinforcement material (F) described later. The flame retardant (D) and the reinforcement material (F) are components optionally contained in the resin composition of the present invention in addition to the resin (A).

Only one of these materials may be used, or a mixture of two or more may be used.

Next, the epoxy compound (B) will be described.

It is only necessary that the epoxy compound (B) have at least one epoxy group in its molecule. The epoxy compound (B) used is generally a glycidyl compound that is a reaction product of alcohol, phenol, carboxylic acid, etc. with epichlorohydrin or a compound obtained by epoxidizing an olefinic double bond.

Examples of the epoxy compound (B) include bisphenol A-type epoxy compounds (B), bisphenol F-type epoxy compounds (B), resorcin-type epoxy compounds (B), novolac-type epoxy compounds (B), alicyclic epoxy compounds (B), glycidyl ethers, glycidyl esters, and epoxidized butadiene polymers.

Examples of the bisphenol A-type epoxy compounds (B) include bisphenol A-diglycidyl ether and hydrogenated bisphenol A-diglycidyl ether, and examples of the bisphenol F-type epoxy compounds (B) include bisphenol F-diglycidyl ether and hydrogenated bisphenol F-diglycidyl ether. Examples of the resorcin-type epoxy compounds (B) include resorcin diglycidyl ether.

Examples of the novolac-type epoxy compounds (B) include phenol novolac-type epoxy resins and cresol novolac-type epoxy resins.

Examples of the alicyclic epoxy compounds (B) include vinylcyclohexene dioxide, dicyclopentadiene oxide, 3,4-epoxycyclohexyl-3,4-cyclohexylcarboxylate, bis(3,4-epoxycyclohexylmethyl)adipate, vinylcyclohexene diepoxide, and 3,4-epoxycyclohexyl glycidyl ether.

Specific examples of the glycidyl ethers include: monoglycidyl ethers such as methyl glycidyl ether, butyl glycidyl ether, 2-ethylhexyl glycidyl ether, decyl glycidyl ether, stearyl glycidyl ether, phenyl glycidyl ether, butyl phenyl glycidyl ether, and allyl glycidyl ether; and diglycidyl ethers such as neopentyl glycol diglycidyl ether, ethylene glycol diglycidyl ether, glycerin diglycidyl ether, propylene glycol diglycidyl ether, and bisphenol A diglycidyl ether. Examples of the glycidyl esters include: monoglycidyl esters such as benzoic acid glycidyl ester and sorbic acid glycidyl ester; and diglycidyl esters such as adipic acid diglycidyl ester, terephthalic acid diglycidyl ester, and o-phthalic acid diglycidyl ester.

Examples of the epoxidized butadiene polymers include epoxidized polybutadiene, epoxidized styrene-butadiene-based copolymers, and epoxidized hydrogenated styrene-butadiene-based copolymers.

The epoxy compound (B) may be a copolymer including a glycidyl group-containing compound as one of its components. One example of such a copolymer is a copolymer of an α,β-unsaturated acid glycidyl ester and one or two or more monomers selected from the group consisting of α-olefins, acrylic acid, acrylates, methacrylic acid, and methacrylates.

Preferably, the epoxy compound (B) has an epoxy equivalent of 100 to 10000 g/eq and a mass average molecular weight of 8000 or less. If the epoxy equivalent is less than 100 g/eq, the number of epoxy groups is excessively large, so that the viscosity of the resin composition is high. If the epoxy equivalent exceeds 10000 g/eq, the number of epoxy group is small, so that the plasma treatment effect and the effect of improving alkali resistance tend not be obtained sufficiently. The epoxy equivalent is more preferably 300 to 7000 g/eq and still more preferably 500 to 6000 g/eq. If the mass average molecular weight exceeds 8000, the compatibility with the resin (A) described later deteriorates, and the mechanical strength of the molded article tends to decrease. The mass average molecular weight is more preferably 7000 or less and still more preferably 6000 or less.

### <Contents>

In some cases, the higher the content of the reactive compound and/or the resin having the reactive functional group in the resin composition of the present invention, the better from the viewpoint of the effect of increasing the plasma treatment effect. However, the content is appropriately determined in consideration of influences on other characteristics of the compounds used. When, for example, a polyamide resin is used, the polyamide resin is added in an amount preferable for the case where a combination of the polyamide resin and the polybutylene terephthalate resin and/or the polycarbonate resin is used as the resin (A), as described later. The same also applies to the epoxy compound (B) etc.

### [Resin (A)]

The resin composition of the present invention contains the resin (A) containing, as a main component, the polybutylene terephthalate resin and/or the polycarbonate resin. The "main component" is a component that is the most abundant among the resin components and is generally a compound contained in the resin (A) in an amount of 50% by mass or more and preferably 60 to 100% by mass.

In the resin composition of the present invention, the main component of the resin (A) is not limited to the polybutylene terephthalate resin and/or the polycarbonate resin, and the resin (A) may contain, as the main component, a thermoplastic resin other than the polybutylene terephthalate resin and/or the polycarbonate resin. Specifically, with the technique of the present invention, even when a thermoplastic resin other than the polybutylene terephthalate resin and/or the polycarbonate resin is used, a metal film can be deposited on the surface of a molded article of the thermoplastic resin with good adhesion, as described above. The thermoplastic resin other than the polybutylene terephthalate resin and/or the polycarbonate resin is one or two or more of polyamide resins described later, styrene-based resins described later, polyester resins other than the polybutylene terephthalate-based resin (aromatic polyester resins and copolymerized aromatic polyester resin such as polyethylene terephthalate, polypropylene terephthalate, polyethylene naphthalate, polybutylene naphthalate, and polyethylene-1,2-bis(phenoxy)ethane-4,4-dicarboxylate, particularly preferably polyethylene terephthalate), polyolefin resins such as polyethylene resins and polypropylene resins, polyimide resins, polyetherimide resins, polyurethane resins, polyphenylene ether resins, polyacetal resins, polyphenylene sulfide resins, polysulfone resins, polymethacrylate resins, phenolic resins, and epoxy resins.

When the resin composition of the present invention contains, as the resin (A), a mixture of the polybutylene terephthalate resin and/or the polycarbonate resin with one or two or more additional resins other than the polybutylene terephthalate resin and/or the polycarbonate resin, the characteristics of these resins can be improved.

As described above, the epoxy resin functions as the reactive component. A polyimide resin, a phenolic resin, etc. may function as the reactive functional group-containing resin described above. In this case, the effect of improving the plasma treatment effect is obtained in some cases.

Representative resins included in the resin (A) in the resin composition of the present invention will be described. However, the main component resin of the resin (A) in the resin composition of the present invention is not limited to the following resins.

### <Polybutylene terephthalate resin>

When the resin composition of the present invention is the polybutylene terephthalate resin composition, the resin composition of the present invention contains the polybutylene terephthalate resin as the main component of the resin (A).

In the present invention, only one polybutylene terephthalate resin may be used, or a combination of two or more may be used. The polycarbonate resin described later may be used in combination with the polybutylene terephthalate resin.

The polybutylene terephthalate resin is a polyester resin having a structure in which a terephthalic acid unit is ester-bonded to an alkanediol unit, and the molded article to be obtained is excellent in mechanical strengths such as bending strength, chemical resistance, moldability, etc. A mixture of the polybutylene terephthalate resin and an additional polyester resin such as a polyethylene terephthalate resin may be used.

The polybutylene terephthalate resin is a polyester resin in which a terephthalic acid unit is ester-bonded to a 1,4-butanediol unit, may be, in addition to the polybutylene terephthalate resin (homopolymer), a polybutylene terephthalate copolymer containing an additional copolymer component other than the terephthalic acid unit and the 1,4-butanediol unit, or may contain a mixture of the homopolymer and the copolymer.

When the polybutylene terephthalate resin contains a dicarboxylic acid unit other than the terephthalic acid, specific examples of the dicarboxylic acid include: aromatic dicarboxylic acids such as isophthalic acid, o-phthalic acid, 1,5-naphthalenedicarboxylic acid, 2,5-naphthalenedicarboxylic acid, 2,6-naphthalenedicarboxylic acid, biphenyl-2,2'-dicarboxylic acid, biphenyl-3,3'-dicarboxylic acid, biphenyl-4,4'-dicarboxylic acid, bis(4,4'-carboxyphenyl)methane, anthracenedicarboxylic acid, and 4,4'-diphenyletherdicarboxylic acid; alicyclic dicarboxylic acids such as 1,4-cyclohexanedicarboxylic acid and 4,4'-dicyclohexyldicarboxylic acid; and aliphatic dicarboxylic acids such as adipic acid, sebacic acid, azelaic acid, and dimer acids.

When the additional dicarboxylic acid other than the terephthalic acid is contained, its copolymerization amount relative to all the segments of the polybutylene terephthalate resin is preferably 1% by mole and less than 50% by mole. In particular, the copolymerization amount is preferably 2% by mole or more and less than 50% by mole, more preferably 3 to 40% by mole, and particularly preferably 5 to 20% by mole.

When the polybutylene terephthalate resin contains an additional diol unit other than 1,4-butanediol, examples of the additional diol include aliphatic and alicyclic diols having 2 to 20 carbon atoms and bisphenol derivatives. Specific examples include ethylene glycol, propylene glycol, 1,5-pentanediol, 1,6-hexanediol, neopentyl glycol, decamethylene glycol, cyclohexanedimethanol, 4,4'-dicyclohexylhydroxymethane, 4,4'-dicyclohexylhydroxypropane, and an ethylene oxide adduct diol of bisphenol A.

When the additional diol unit other than 1,4-butanediol is contained, its copolymerization amount relative to all the segments of the polybutylene terephthalate resin is preferably 1% by mole or more and less than 50% by mole. In particular, the copolymerization amount is preferably 2% by mole or more and less than 50% by mole, more preferably 3 to 40% by mole, and particularly preferably 5 to 20% by mole.

In the polybutylene terephthalate resin, a small amount of a trifunctional monomer such as trimellitic acid, trimesic acid, pyromellitic acid, pentaerythritol, or trimethylolpropane may be used in combination with the above bifunctional monomers in order to introduce a branched structure. Moreover, to control the molecular weight, a small amount of a monofunctional compound such as aliphatic acid may be used in combination with the above bifunctional monomers.

The polybutylene terephthalate resin is preferably a polybutylene terephthalate homopolymer obtained by polycondensation of terephthalic acid and 1,4-butanediol. The polybutylene terephthalate resin may be a polybutylene terephthalate copolymer containing at least one dicarboxylic acid other than terephthalic acid as a carboxylic acid unit and/or at least one diol other than 1,4-butanediol as a diol unit. From the viewpoint of mechanical properties and heat resistance, the ratio of the terephthalic acid unit in the dicarboxylic acid units in the polybutylene terephthalate resin is preferably 50% by mole or more, more preferably 70% by mole or more, and still more preferably 90% by mole or more. Similarly, the ratio of the 1,4-butanediol unit in the diol units is preferably 50% by mole or more, more preferably 70% by mole or more, and still more preferably 90% by mole or more.

When a copolymer is used as the polybutylene terephthalate resin, it is particularly preferable to use a polyester ether resin obtained by copolymerization with polytetramethylene glycol. The ratio of the tetramethylene glycol component in the copolymer is preferably 3 to 40% by mass, more preferably 5 to 30% by mass, and still more preferably 10 to 25% by mass.

The polybutylene terephthalate resin can be produced by melt-polymerizing a dicarboxylic acid component including terephthalic acid as a main component or an ester derivative thereof and a diol component including 1,4-butanediol as a main component using a batch process or a continuous process. After the production of the polybutylene terephthalate resin having a low molecular weight by melt polymerization, the polybutylene terephthalate resin may be subjected to solid phase polymerization in a nitrogen gas flow or under reduced pressure to increase the degree of polymerization (or the molecular weight) to a desired value.

The polybutylene terephthalate resin is preferably a resin obtained by a production method in which a dicarboxylic acid including terephthalic acid as a main component and a diol component including 1,4-butanediol as a main component are subjected to melt polycondensation using a continuous process.

A catalyst used for an esterification reaction may be a well-known conventional catalyst, and examples thereof include titanium compounds, tin compounds, magnesium compounds, and calcium compounds. Of these, titanium compounds are particularly preferred. Specific examples of the titanium compounds used as the esterification catalyst include: titanium alcoholates such as tetramethyl titanate, tetraisopropyl titanate, and tetrabutyl titanate; and titanium phenolates such as tetraphenyl titanate.

The amount of terminal carboxyl groups in the polybutylene terephthalate resin may be appropriately selected and determined and is generally 60 eq/ton or less, preferably 50 eq/ton or less, and still more preferably 30 eq/ton. If the amount of the terminal carboxyl groups exceeds 50 eq/ton, gas tends to be generated during melt molding of the resin composition. The lower limit of the amount of the terminal carboxyl groups is not particularly specified. In consideration of productivity when the polybutylene terephthalate resin is produced, the lower limit is generally 10 eq/ton.

The amount of the terminal carboxyl groups in the polybutylene terephthalate resin is a value measured by dissolving 0.5 g of the polybutylene terephthalate resin in 25 mL of benzyl alcohol and performing titration using a 0.01 mole/L benzyl alcohol solution of sodium hydroxide. The amount of the terminal carboxyl groups may be controlled using a well-known method such as a method in which polymerization conditions such as the ratio of raw materials used for the polymerization, polymerization temperature, a pressure reduction method are adjusted or a method in which a terminal-blocking agent is reacted.

The intrinsic viscosity of the polybutylene terephthalate resin is preferably 0.5 to 2 dL/g. From the viewpoint of moldability and mechanical properties, the intrinsic viscosity is preferably in the range of 0.6 to 1.5 dL/g. When the polybutylene terephthalate resin used has an intrinsic viscosity of less than 0.5 dL/g, the mechanical strength of the molded article to be obtained tends to be low. When the polybutylene terephthalate resin used has an intrinsic viscosity of higher than 2 dL/g, the flowability of the resin composition is low, and its moldability may deteriorate.

The intrinsic viscosity of the polybutylene terephthalate resin is a value measured at 30°C in a solvent mixture of tetrachloroethane and phenol at a ratio of 1:1 (mass ratio).

### <Polycarbonate resin>

When the resin composition of the present invention is the polycarbonate resin composition, the resin composition of the present invention contains the polycarbonate resin as a main component of the resin (A).

In the present invention, only one polycarbonate resin may be used, or a combination of two or more may be used. In addition to the polycarbonate resin, the polybutylene terephthalate resin described above may be contained.

When the resin composition of the present invention contains the polycarbonate resin, particularly an aromatic polycarbonate resin, as the resin (A), dimensional stability, shape stability, heat resistance, shock resistance, bending strength, etc. can be improved.

The aromatic polycarbonate resin is an optionally branched thermoplastic polymer or copolymer obtained by reacting an aromatic dihydroxy compound or a combination of the aromatic dihydroxy compound and a small amount of a polyhydroxy compound with phosgene or carbonic acid diester. No particular limitation is imposed on the method for producing the aromatic polycarbonate resin, and the aromatic polycarbonate resin used may be produced by a well-known phosgene method (interfacial polymerization method) or a melting method (trans esterification method). When the melting method is used, an aromatic polycarbonate resin in which the amount of terminal hydroxy groups is controlled can be used.

Examples of the aromatic dihydroxy compound used as a raw material include 2,2-bis(4-hydroxyphenyl)propane (= bisphenol A), tetramethyl bisphenol A, bis(4-hydroxyphenyl)-p-diisopropylbenzene, hydroquinone, resorcinol, and 4,4-dihydroxydiphenyl, and bisphenol A is preferred. A compound in which at least one tetraalkyl phosphonium sulfonate molecule is bonded to the aromatic dihydroxy compound may be used.

To obtain a branched aromatic polycarbonate resin, part of the above-described aromatic dihydroxy compound is replaced with one of the following branching agents, i.e., polyhydroxy compounds such as phloroglucine, 4,6-dimethyl-2,4,6-tri(4-hydroxyphenyl)heptene-2, 4,6-dimethyl-2,4,6-tri(4-hydroxyphenyl)heptane, 2,6-dimethyl-2,4,6-tri(4-hydroxyphenylheptene-3,1,3,5-tri(4-hydroxyphenyl)benzene, and 1,1,1-tri(4-hydroxyphenyl)ethane and compounds such as 3,3-bis(4-hydroxyaryl)oxindole (= isatin bisphenol), 5-chloroisatin, 5,7-dichloroisatin, and 5-bromoisatin. The amount of the compound used for replacement relative to the aromatic dihydroxy compound is generally 0.01 to 10% by mole and preferably 0.1 to 2% by mole.

Among the above materials, the aromatic polycarbonate resin is preferably a polycarbonate resin derived from 2,2-bis(4-hydroxyphenyl)propane or a polycarbonate copolymer derived from 2,2-bis(4-hydroxyphenyl)propane and another aromatic dihydroxy compound. The aromatic polycarbonate resin may be a copolymer composed mainly of a polycarbonate resin such as a copolymer and a polymer or oligomer having a siloxane structure.

One of the above aromatic polycarbonate resins may be used alone, or a mixture of two or more may be used.

To control the molecular weight of the aromatic polycarbonate resin, a monovalent aromatic hydroxy compound may be used. Examples of the monovalent aromatic hydroxy compound include m-methylphenol, p-methylphenol, m-propylphenol, p-propylphenol, p-tert-butylphenol, and p-long chain alky-substituted phenol.

The molecular weight of the polycarbonate resin used in the present invention is a viscosity average molecular weight converted from a solution viscosity measured at a temperature of 25°C using methylene chloride as a solvent and is preferably 100 to 80,000 and more preferably 1,000 to 60,000. When the viscosity average molecular weight of the polycarbonate resin is equal to or higher than the above lower limit, its mechanical properties tend to be high. When the viscosity average molecular weight is equal to or lower than the upper limit, its flowability is good, and good moldability tends to be obtained.

The polycarbonate resin used may be a mixture of two or more polycarbonate resins having different viscosity average molecular weights. In this case, a polycarbonate resin having a viscosity average molecular weight outside the above range may be mixed. In this case, it is preferable that the viscosity average molecular weight of the mixture used is in the above range.

### <Polyamide resin>

The resin composition of the present invention may contain, as the resin (A), a polyamide resin in addition to the polybutylene terephthalate resin and/or the polycarbonate resin. When the polyamide resin is contained, alkali resistance is improved, and the plasma treatment effect described above can be improved through the reactivity of the amido groups contained in the polyamide resin, so that a metal film with high adhesion can be obtained.

The polyamide resin is a polyamide polymer that has acid amido groups (-CONH-) in its molecule and can be heat-melted. Specific examples of the polyamide resin include various polyamide resins such as polycondensates of lactams, polycondensates of diamine compounds and dicarboxylic acid compounds, polycondensates of ω-aminocarboxylic acids, copolymerized polyamide resins thereof, and blends thereof.

Examples of the lactams used as the raw materials of the polycondensates for the polyamide resin include ε-caprolactam and ω-laurolactam.

Examples of the diamine compounds include aliphatic, alicyclic, and aromatic diamines such as tetramethylenediamine, hexamethylenediamine, undecamethylenediamine, dodecamethylenediamine, 2-methylpentamethylenediamine, (2,2,4- or 2,4,4-)trimethylhexamethylenediamine, 5-methylnonamethylenediamine, m-xylylenediamine (MXDA), p-xylylenediamine, 1,3-bis(aminomethyl)cyclohexane, 1,4-bis(aminomethyl)cyclohexane, 1-amino-3-aminomethyl-3,5,5-trimethylcyclohexane, bis(4-aminocyclohexyl)methane, bis(3-methyl-4-aminocyclohexyl)methane, 2,2-bis(4-aminocyclohexyl)propane, bis(aminopropyl)piperazine, and aminoethylpiperazine.

Examples of the dicarboxylic acid compounds include aliphatic, alicyclic, and aromatic dicarboxylic acids such as adipic acid, suberic acid, azelaic acid, sebacic acid, dodecanedioic acid, terephthalic acid, isophthalic acid, 2-chloroterephthalic acid, 2-methylterephthalic acid, 5-methylisophthalic acid, 5-sodium sulfoisophthalic acid, hexahydroterephthalic acid, and hexahydroisophthalic acid.

Examples of the ω-aminocarboxylic acids include amino acids such as 6-aminocaproic acid, 11-aminoundecanoic acid, 12-aminododecanoic acid, and p-aminomethylbenzoic acid.

Specific examples of the polyamide resin prepared by polycondensation of these raw materials include polyamide 4, polyamide 6, polyamide 11, polyamide 12, polyamide 46, polyamide 66, polyamide 610, polyamide 612, polyhexamethylene terephthalamide (polyamide 6T), polyhexamethylene isophthalamide (polyamide 61), polymetaxylylene adipamide (polyamide MXD6), polymetaxylylene dodecanamide, polyamide 9T, and polyamide 9MT. In the present invention, any of homopolymers and copolymers of these polyamides may be used alone, or a mixture of any of the polymers and copolymers may be used.

Preferably, the degree of polymerization, i.e., the viscosity, of the polyamide resin is in a specific range. Specifically, it is preferable that the viscosity number measured in 96% by mass sulfuric acid containing the polyamide resin at a concentration of 1% by mass at a temperature of 23°C according to ISO307 standard is 70 to 200 mL/g. A viscosity number of 70 mL/g or more is preferred because mechanical properties are improved. A viscosity number of 200 mL/g or less is preferred because moldability tends to be improved. A more preferred range of the viscosity number is 70 to 150 mL/g, and a particularly preferable range is 70 to 130 mL/g.

The content of the terminal carboxyl groups in the polyamide resin may be appropriately selected and determined and is preferably 35 µeq/g or more, more preferably 40 µeq/g or more, still more preferably 45 µeq/g or more, and particularly preferably 50 µeq/g or more. The upper limit is generally 140 µeq/g, preferably 130 µeq/g, and more preferably 120 µeq/g. The content of the terminal amino groups is preferably 10 µeq/g or more, more preferably 15 µeq/g or more, and still more preferably 20 µeq/g or more, and its upper limit is generally 100 µeq/g, preferably 80 µeq/g, and more preferably 70 µeq/g. The above contents of the terminal groups are preferred because alkali resistance and the plasma treatment tend to be improved.

The content of the terminal carboxyl groups in the polyamide resin can be measured by dissolving the polyamide resin in benzyl alcohol and performing titration with 0.01N caustic soda. The content of the terminal amino groups can be measured by dissolving the polyamide resin in phenol and performing titration with 0.01N hydrochloric acid. The content of the terminal carboxyl groups and the content of the terminal amino groups can be controlled by a well-known conventional method such as a method in which the polymerization conditions such as the ratio of the raw materials used for the polymerization, the polymerization temperature, and a pressure reduction method are controlled or a method in which a terminal-blocking agent is reacted.

The polyamide resin means a ring-opened polymer of a lactam, a polymer obtained by polycondensation of a diaminocarboxylic acid, or a polymer obtained by polycondensation of an amine and a dibasic acid or compounds equivalent thereto. Examples of the lactam include propiolactam, α-pyrrolidone, ε-caprolactam, enantholactam, ω-laurolactam, and cyclododecalactam, and examples of the diaminocarboxylic acid include aminocaproic acid, 7-aminoheptanoic acid, 11-aminoundecanoic acid, and 9-aminononanoic acid. Examples of the amine include hexamethylenediamine, m-xylylenediamine, and p-xylylenediamine, and examples of the dibasic acid include terephthalic acid, isophthalic acid, adipic acid, sebacic acid, dodecanoic dibasic acid, and glutaric acid.

A first embodiment of the polyamide resin is an aliphatic polyamide resin.

More specific examples of the aliphatic polyamide resin include polyamide 4, polyamide 6, polyamide 7, polyamide 8, polyamide 11, polyamide 12, polyamide 66, polyamide 69, polyamide 610, polyamide 611, polyamide 612, polyamide 6/66, and polyamide 6/12. Any of these polyamide resins may be used alone, or a mixture of two or more may be used. Of these, a polyamide resin whose melting point is not largely different from the melting point of the thermoplastic polyester resin is preferred. In the case of the polybutylene terephthalate resin, polyamide 6, a polyamide 6/66 copolymer, or polyamide 66 is preferred, and polyamide 6 is more preferred.

A second embodiment of the polyamide resin is a semi-aromatic polyamide resin. The semi-aromatic polyamide resin includes a structural unit derived from diamine and a structural unit derived from dicarboxylic acid, and 30 to 70% by mole of the total of the structural unit derived from diamine and the structural unit derived from dicarboxylic acid is a structural unit including an aromatic ring. Preferably, 40 to 60% by mole of the total of the structural unit derived from diamine and the structural unit derived from dicarboxylic acid is the structural unit including an aromatic ring. When such a semi-aromatic polyamide resin is used, the mechanical strength of the molded resin article to be obtained can be increased. Examples of the semi-aromatic polyamide resin include polyamide 6T, polyamide 9T, and xylylenediamine-based polyamide resins described later.

The polyamide resin in the second embodiment is preferably at least one polyamide resin which includes the structural unit derived from diamine and the structural unit derived from dicarboxylic acid, in which 70% by mole or more of the structural unit derived from diamine is derived from xylylenediamine, and in which 70% by mole or more of the structural unit derived from dicarboxylic acid is derived from α,ω-linear aliphatic dicarboxylic acid having 4 to 20 carbon atoms (preferably adipic acid or sebacic acid and more preferably adipic acid) (this polyamide resin may be hereinafter referred to as a "xylylenediamine-based polyamide resin").

More preferably, 80% by mole or more of the structural unit derived from diamine in the xylylenediamine-based polyamide resin is derived from xylylenediamine. Still more preferably, 85% by mole or more is derived from the xylylenediamine. Yet more preferably, 90% by mole or more is derived from the xylylenediamine. Even more preferably, 95% by mole or more is derived from the xylylenediamine. More preferably, 80% by mole or more of the structural unit derived from dicarboxylic acid in the xylylenediamine-based polyamide resin is derived from α,ω-linear aliphatic dicarboxylic acid having 4 to 20 carbon atoms. Still more preferably, 85% by mole or more is derived from the α,ω-linear aliphatic dicarboxylic acid. Yet more preferably, 90% by mole or more is derived from the α,ω-linear aliphatic dicarboxylic acid. Even more preferably, 95% by mole or more is derived from the α,ω-linear aliphatic dicarboxylic acid.

The xylylenediamine is preferably p-xylylenediamine or m-xylylenediamine, and a mixture of m-xylylenediamine and p-xylylenediamine is more preferred.

Specific examples of the semi-aromatic polyamide resin include polyamide 6T, polyamide 6/6T, polyamide 6/61, polyamide 6I/6T, a polycondensate of m-xylylenediamine and adipic acid (polyamide MXD6), a polycondensate of adipic acid and a diamine mixture of m-xylylenediamine and p-xylylenediamine (polyamide PAMP6), and a polycondensate of p-xylylenediamine and sebacic acid (polyamide PXD10). Of these, MXD6 and PAMP6 are preferred, and PAMP6 is more preferred.

The relative viscosity of the polyamide resin is a relative viscosity measured in 98% sulfuric acid at a concentration of 1% by mass and a temperature of 25°C and is generally 1.6 to 4.0 and preferably 2.0 to 3.8. If the relative viscosity is less than 1.6, the resin composition to be obtained tends to be brittle. If the relative viscosity exceeds 4, the flowability during molding of the resin composition may be insufficient.

The content of the terminal carboxyl groups in the polyamide resin may be appropriately selected and determined and is preferably 35 µeq/g or more, more preferably 40 µeq/g or more, still more preferably 45 µeq/g or more, and particularly preferably 50 µeq/g or more. Its upper limit is generally 140 µeq/g or less, preferably 130 µeq/g or less, and more preferably 120 µeq/g or less. The content of the terminal amino groups is preferably 10 µeq/g or more, more preferably 15 µeq/g or more, and still more preferably 20 µeq/g or more, and its upper limit is generally 100 µeq/g or less, preferably 80 µeq/g or less, and more preferably 70 µeq/g or less. The above contents of the terminal groups are preferred because alkali resistance and heat shock resistance tend to be improved.

The content of the terminal carboxyl groups in the polyamide resin can be measured by dissolving the polyamide resin in benzyl alcohol and performing titration with 0.01N caustic soda. The content of the terminal amino groups can be measured by dissolving the polyamide resin in phenol and performing titration with 0.01N hydrochloric acid. The content of the terminal carboxyl groups and the content of the terminal amino groups can be controlled by a well-known conventional method such as a method in which the polymerization conditions such as the ratio of the raw materials used for the polymerization, the polymerization temperature, and a pressure reduction method are controlled or a method in which a terminal-blocking agent is reacted.

The water absorption rate of the polyamide resin is preferably 0.5% by mass or more, more preferably 1.0% by mass or more and is preferably 2.5% by mass or less and more preferably 2.0% by mass or less. By using a polyamide resin having such a water absorption rate, the formation of the metal film can be further improved.

### <Styrene-based resin>

The resin composition of the present invention may contain, as the resin (A), a styrene-based resin in addition to the polybutylene terephthalate resin and/or the polycarbonate resin. When the resin composition of the present invention contains the styrene-based resin, warpage can be reduced, and the effect of improving moldability can be obtained.

Examples of the styrene-based resin include polystyrene, copolymers of styrene and (meth)acrylonitrile, and copolymers of styrene, (meth)acrylonitrile, and another copolymerizable monomer. The styrene means the following styrene-based monomers.

Examples of the styrene-based monomers include styrene, α-methylstyrene, and p-methylstyrene, and preferred examples include styrene. Examples of the monomer copolymerizable with the styrene-based monomer include: alkyl (meth)acrylates such as methyl acrylate, ethyl acrylate, propyl acrylate, methyl methacrylate, and ethyl methacrylate; maleic anhydride; maleimide; and N-phenylmaleimide, and preferred examples include alkyl (meth)acrylates.

Examples of a method for producing the styrene-based resin include well-known methods such as an emulsion polymerization method, a solution polymerization method, a suspension polymerization method, and a bulk polymerization method.

The styrene-based resin is preferably polystyrene or an acrylonitrile-styrene copolymer (AS resin), and the AS resin is more preferred.

The styrene-based resin may contain an additional rubber component other than acrylic rubber so long as the effects of the present invention are not impaired. Examples of the additional rubber component include:
polyorganosiloxane-based rubbers produced by polymerizing 3- or higher-membered cyclic organosiloxanes, preferably 3 to 6-membered cyclic organosiloxane monomers; and diene-based rubbers formed of conjugated diene compounds such as butadiene, isoprene, pentadiene, and 2,3-dimethylbutadiene. Of these, polystyrenes containing a butadiene rubber component are preferred, and high impact polystyrene resins (HIPS resins) are more preferred.

### <Resin contents>

When the resin composition of the present invention is the polybutylene terephthalate-based resin composition containing the polybutylene terephthalate resin as a main component of the resin (A), the content of the polybutylene terephthalate resin is 50 to 100 parts by mass, preferably more than 50 parts by mass, more preferably 55 parts by mass or more, and still more preferably 60 to 100 parts by mass based on 100 parts by mass of the resin (A) as a whole.

When the resin composition of the present invention is the polycarbonate-based resin composition containing the polycarbonate resin as a main component of the resin (A), the content of the polycarbonate resin is 50 to 100 parts by mass, preferably more than 50 parts by mass, more preferably 55 parts by mass or more, and still more preferably 60 to 100 parts by mass based on 100 parts by mass of the resin (A) as a whole.

When the resin composition of the present invention is a polybutylene terephthalate/polycarbonate-based resin composition containing the polybutylene terephthalate resin and the polycarbonate resin as main components of the resin (A), the total content of the polybutylene terephthalate resin and the polycarbonate resin is 50 to 100 parts by mass, preferably more than 50 parts by mass, more preferably 55 parts by mass or more, and still more preferably 60 to 100 parts by mass based on 100 parts by mass of the resin (A) as a whole.

When the resin composition of the present invention is the polybutylene terephthalate-based resin composition containing the polybutylene terephthalate resin as a main component of the resin (A) and further containing the polycarbonate resin as the resin (A), dimensional stability, shape stability, heat resistance, shock resistance, bending strength, etc. can be improved. In this case, the content of the polycarbonate resin is preferably 1 to 50 parts by mass, particularly preferably 2 to 40 parts by mass, and most preferably 5 to 40 parts by mass based on 100 parts by mass of the resin (A) as a whole in the resin composition of the present invention. When the content of the polycarbonate resin is equal to or higher than the above lower limit, the above-described effects of the polycarbonate resin contained can be obtained sufficiently. When the content is equal to or lower than the above upper limit, the metal film tends to be formed easily.

When the resin composition of the present invention is the polycarbonate-based resin composition containing the polycarbonate resin as a main component of the resin (A) and further containing the polybutylene terephthalate resin as the resin (A), electrical properties, chemical resistance, flowability, heat resistance, etc. can be improved. In this case, the content of the polybutylene terephthalate resin is preferably 1 to 50 parts by mass, particularly preferably 2 to 40 parts by mass, and most preferably 5 to 40 parts by mass based on 100 parts by mass of the resin (A) as a whole in the resin composition of the present invention. When the content of the polybutylene terephthalate resin is equal to or higher than the above lower limit, the above-described effects of the polybutylene terephthalate resin contained can be obtained sufficiently. When the content is equal to or lower than the above upper limit, the effects on dimensional stability, shape stability, shock resistance, etc. that are obtained when the polycarbonate resin is contained as the main component can be obtained sufficiently.

When the resin composition of the present invention contains the polyamide resin as the resin (A), its content is preferably 0.5 to 50 parts by mass, particularly preferably 5 to 50 parts by mass, and most preferably 10 to 40 parts by mass based on 100 parts by mass of the resin (A) as a whole in the resin composition of the present invention. When the content of the polyamide resin is equal to or higher than the above lower limit, the effect of improving alkali resistance and the effect of improving the plasma treatment effect that are obtained when the polyamide resin is contained can be obtained sufficiently. When the content of the polyamide resin is equal to or lower than the above upper limit, the polyamide resin is dispersed in the resin composition sufficiently, and a reduction in heat resistance and mechanical properties can be prevented.

When the resin composition of the present invention contains the styrene-based resin as the resin (A), its content is preferably 1 to 50 parts by mass, particularly preferably 5 to 50 parts by mass, and most preferably 10 to 50 parts by mass based on 100 parts by mass of the resin (A) as a whole in the resin composition of the present invention. When the content of the styrene resin is equal to or higher than the above lower limit, the above-described effects of the styrene resin contained can be obtained sufficiently. When the content is equal to or lower than the above upper limit, flowability is significantly improved, and moldability tends to be improved.

When the resin composition of the present invention contains an additional resin other than the polyamide resin and the styrene-based resin, the content of the additional resin is preferably 50 parts by mass or less and particularly preferably 30 parts by mass or less based on 100 parts by mass of the resin (A) as a whole in the resin composition of the present invention.

### [Polybutylene terephthalate-based resin composition]

A description will be given of components other than the resin (A) that are optionally contained in the resin composition of the present invention when the resin composition is the polybutylene terephthalate-based resin composition containing the polybutylene terephthalate resin as a main component of the resin (A).

### <Epoxy compound (B)>

The polybutylene terephthalate-based resin composition of the present invention may contain the epoxy compound (B) serving as the reactive component described above. When the epoxy compound is contained, its reactive epoxy group allows the plasma treatment effect described above to be improved. The polybutylene terephthalate-based resin may undergo hydrolysis when exposed to water vapor etc., and this may cause a reduction in molecular weight and a reduction in mechanical strength etc. However, the epoxy compound (B) has the effect of preventing the reduction in molecular weight and the reduction in mechanical strength etc. and exhibits the effect of further improving alkali resistance, hydrolysis resistance, and heat shock resistance in synergy with the polyamide resin and an elastomer (C) described later.

When the polybutylene terephthalate resin and the polyamide resin are contained as the resin (A), the epoxy compound (B) is preferably a bisphenol A-type epoxy compound (B) or a novolac-type epoxy compound (B) obtained by a rection of bisphenol A or novolac with epichlorohydrin. In particular, the bisphenol A-type epoxy compound (B) is preferred because its high reactivity with the polyamide resin allows the polyamide resin to be easily dispersed, so that alkali resistance tends to be improved. The bisphenol A-type epoxy compound (B) is particularly preferable also in terms of hydrolysis resistance.

When the polybutylene terephthalate-based resin composition of the present invention containing, as the resin (A), the polyamide resin together with the polybutylene terephthalate resin contains the epoxy compound (B), its content is preferably 1 to 15 parts by mass, more preferably 3 parts by mass or more, still more preferably 4 parts by mass or more, and particularly preferably 4.5 parts by mass or more based on 100 parts by mass of the resin (A). The content is more preferably 13 parts by mass or less, still more preferably 10 parts by mass or less, and particularly preferably 8 parts by mass or less. When the content of the epoxy compound (B) is equal to or higher than the above lower limit, a reduction in alkali resistance and a reduction in hydrolysis resistance due to insufficient dispersion of the polyamide resin are unlikely to occur. When the content is equal to or lower than the above upper limit, deterioration in flowability during molding due to the progress of crosslinking may not occur.

When the polybutylene terephthalate-based resin composition of the present invention does not contain the above-described polyamide resin as the resin (A), the content of the epoxy compound (B) is less than the above range, and the effects of addition are sufficient even when the content is 0.005 to 10 parts by mass, particularly about 0.05 to about 5 parts by mass, based on 100 parts by mass of the resin (A).

Preferably, the epoxy compound (B) is mixed such that the equivalent ratio of the epoxy groups in the epoxy compound (B) to the terminal carboxyl groups in the polybutylene terephthalate-based resin in the polybutylene terephthalate-based resin composition of the present invention (the epoxy groups/the carboxyl groups) is in the range of 0.2 to 2.7. When the ratio of the epoxy groups/the carboxyl groups is equal to or higher than the above lower limit, a reduction in hydrolysis resistance can be prevented. When the ratio is equal to or lower than the above upper limit, moldability tends to be stabilized. The ratio of the epoxy groups/the carboxyl groups is more preferably 0.3 to 2.5.

### <Elastomer (C)>

The polybutylene terephthalate-based resin composition of the present invention may contain an elastomer (C). When the elastomer (C) is contained, alkali resistance, hydrolysis resistance, heat shock resistance, and toughness can be imparted to the molded article.

No particular limitation is imposed on the elastomer (C), and examples thereof include (C-1), (C-2), and (C-3) below.
(C-1) A copolymer of α-olefin, an unsaturated glycidyl compound, and butyl acrylate
(C-2) A core/shell-type elastomer including a core layer containing a polyorganosiloxane-based rubber component and an acrylic-based rubber component and an aromatic vinyl-based polymer disposed on the core layer
(C-3) A core/shell-type elastomer including a core layer containing a polyorganosiloxane-based rubber component and an acrylic-based rubber component and a glycidyl-modified acrylate-based polymer disposed on the core layer

### <(C-1) Copolymer of α-olefin, unsaturated glycidyl compound, and butyl acrylate>

The copolymer (C-1) of α-olefin, an unsaturated glycidyl compound, and butyl acrylate may be not only a ternary copolymer of the α-olefin, the unsaturated glycidyl compound, and the butyl acrylate but also a quaternary or higher copolymer of the α-olefin, the unsaturated glycidyl compound, the butyl acrylate, and an additional monomer.

Examples of the α-olefin in the copolymer (C-1) include α-olefins having 2 to 8 carbon atoms such as ethylene, propylene, 1-butene, and 1-pentene, and ethylene is particularly preferable.

The unsaturated glycidyl compound is preferably glycidyl (meth)acrylate or unsaturated glycidyl ether such as vinyl glycidyl ether, allyl glycidyl ether, or 2-methylallyl glycidyl ether, and glycidyl acrylate or glycidyl methacrylate is particularly preferred.

Examples of the additional monomer that can be used as a component of the quaternary or higher copolymer include: (meth)acrylates such as methyl acrylate, ethyl acrylate, propyl acrylate, octyl acrylate, 2-ethylhexyl acrylate, methyl methacrylate, ethyl methacrylate, propyl methacrylate, butyl methacrylate, octyl methacrylate, 2-ethylhexyl methacrylate, dimethyl maleate, and diethyl maleate; vinyl esters such as vinyl acetate and vinyl propionate; acrylonitrile; styrene; carbon monoxide; and maleic anhydride.

In the copolymer (C-1) of the α-olefin, the unsaturated glycidyl compound, and the butyl acrylate, preferred contents of these copolymerized components when the total mass of all the components of (C-1) is set to 100% by mass are as follows. The content of the α-olefin is preferably 50 to 94.5% by mass, more preferably 52 to 85% by mass, and still more preferably 55 to 75% by mass, and the content of the unsaturated glycidyl compound is preferably 0.5 to 20% by mass, more preferably 1 to 18% by mass, still more preferably 2 to 15% by mass, and particularly preferably 3 to 10% by mass. The content of the butyl acrylate is preferably 5 to 49.5% by mass, more preferably 7 to 45% by mass, still more preferably 10 to 40% by mass, and particularly preferably 15 to 35% by mass, and the content of the additional monomer other than the above components is preferably 0 to 49.5% by mass, more preferably 0.5 to 40% by mass, and still more preferably 1 to 35% by mass.

If the content of the unsaturated glycidyl compound is excessively low, the heat resistance of the polybutylene terephthalate-based resin composition of the present invention may deteriorate. If the content is excessively high, the viscosity of the resin increases abruptly, so that molding is difficult to perform. Another problem is that a gel may be formed in the composition. When a copolymer in which the butyl acrylate is copolymerized within the above range is used, good flexibility can be easily imparted to the polybutylene terephthalate-based resin composition.

The copolymer (C-1) of the α-olefin, the unsaturated glycidyl compound, and the butyl acrylate may be a random copolymer or a graft copolymer, and it is preferable to use a random copolymer. The random copolymer can be obtained by, for example, radical copolymerization at high temperature and high pressure.

The melt flow rate of the copolymer (C-1) of the α-olefin, the unsaturated glycidyl compound, and the butyl acrylate (measured at 190°C under a load of 2.16 kg according to JIS K7210-1999) is preferably 0.01 to 1000 g/10 minute, more preferably 0.1 to 200 g/10 minute, and particularly preferably 1 to 70 g/10 minute.

When the polybutylene terephthalate-based resin composition of the present invention contains the copolymer (C-1) of the α-olefin, the unsaturated glycidyl compound, and the butyl acrylate, its content is preferably in the range of 1 to 15 parts by mass, more preferably 2 to 13 parts by mass, and particularly preferably in the range of 3 to 10 parts by mass based on 100 parts by mass of the resin (A). When the content is equal to or higher than the above lower limit, the intended effect of improving alkali resistance etc. can be obtained sufficiently. When the content is equal to or lower than the above upper limit, heat resistance and mechanical properties such as stiffness can be maintained.

### <(C-2) Core/shell-type elastomer including core layer containing polyorganosiloxane-based rubber component and acrylic-based rubber component and aromatic vinyl-based polymer disposed on core layer>

The core/shell-type elastomer (C-2) is a core/shell-type elastomer including the core layer containing the polyorganosiloxane-based rubber component and the acrylic-based rubber component and the aromatic vinyl-based polymer disposed on the core layer.

The rubber layer of the core/shell-type elastomer (C-2) must contain at least the polyorganosiloxane-based rubber component and the acrylic-based rubber component.

The polyorganosiloxane-based rubber component is produced by polymerizing an organosiloxane monomer, and the organosiloxane used is a 3- or higher-membered cyclic organosiloxane and is preferably a 3- to 6-membered cyclic organosiloxane. Examples of the organosiloxane used include hexamethyltricyclosiloxane, octamethylcyclosiloxane, decamethylpentacyclosiloxane, dodecamethylhexacyclosiloxane, trimethylphenylsiloxane, tetramethylphenylcyclotetrasiloxane, and octaphenylcyclotetrasiloxane.

A crosslinking agent used to prepare the polyorganosiloxane rubber is a trifunctional or tetrafunctional crosslinking agent, i.e., trialkoxyalkyl or aryl silane or tetraalkoxysilane. Specific examples of the crosslinking agent include trimethoxymethylsilane, triethoxyphenylsilane, tetramethoxysilane, tetraethoxysilane, tetra-n-propoxysilane, and tetrabutoxysilane. The crosslinking agent used is preferably tetraalkoxysilane and particularly preferably tetraethoxysilane.

Preferably, the acrylic-based rubber component is obtained by polymerizing alkyl (meth)acrylate such as butyl acrylate and a small amount of a crosslinkable monomer such as butylene diacrylate. Examples of the (meth)acrylate include, in addition to butyl acrylate, methyl acrylate, ethyl acrylate, propyl acrylate, pentyl acrylate, hexyl acrylate, heptyl acrylate, octyl acrylate, 2-ethylhexyl acrylate, and methyl, ethyl, propyl, butyl, octyl, 2-ethylhexyl, lauryl, stearyl esters of methacrylic acid. Examples of the crosslinkable monomer include, in addition to butylene diacrylate: vinyl compounds such as butylene dimethacrylate, ethylene glycol diacrylate, ethylene glycol dimethacrylate, butylene glycol diacrylate, butylene glycol dimethacrylate, oligoethylene glycol diacrylate, trimethylolpropane diacrylate, trimethylolpropane dimethacrylate, and trimethylolpropane trimethacrylate; and allyl compounds such as allyl acrylate, allyl methacrylate, diallyl maleate, diallyl fumarate, diallyl itaconate, monoallyl malate, monoallyl fumarate, and triallyl cyanurate.

The above rubber components may contain a conjugated diene compound, and examples of the conjugated diene compound include butadiene, isoprene, pentadiene, and 2,3-dimethylbutadiene. The copolymerization amount of the conjugated diene compound is preferably as small as about 10% by mass or less.

The core layer may be a mixture of the polyorganosiloxane-based rubber component and the acrylic-based rubber component, and a composite-based rubber prepared by subjecting these components to copolymerization and/or graft polymerization may be used. It is also preferable to use a composite rubber prepared by integrating the polyorganosiloxane-based rubber component and the acrylic-based rubber component through chemical bonding obtained by copolymerization and/or graft polymerization, i.e., a silicone acrylic composite rubber.

The mass ratio of the polyorganosiloxane-based rubber component to the acrylic-based rubber component, i.e., the polyorganosiloxane-based rubber component/the acrylic-based rubber component, is preferably 99/1 to 1/99 from the viewpoint of the effect of improving alkali resistance and shock resistance. In an alkaline environment, ester groups in the acrylic rubber component may undergo alkaline hydrolysis. When the amount of the acrylic-based rubber component is excessively large, its function as the rubber component deteriorates. Therefore, the mass ratio of the polyorganosiloxane-based rubber component to the acrylic-based rubber component is preferably 95/5 to 15/85 and still more preferably 90/10 to 30/70.

The shell layer in the core/shell-type elastomer (C-2) must contain at least the aromatic vinyl-based polymer.

Examples of the aromatic vinyl compound include styrene, α-methylstyrene, methylstyrene, vinylxylene, monochlorostyrene, dichlorostyrene, monobromostyrene, dibromostyrene, fluorostyrene, p-tert-butylstyrene, ethylstyrene, and vinylnaphthalene. Of these, styrene is preferred because of its low cost and ease of handling during polymerization.

The aromatic vinyl-based polymer may be a homopolymer or a copolymer.

The copolymer is preferably obtained by copolymerizing at least one monomer selected from a vinyl cyanide monomer, a methacrylate-based monomer, and an acrylate-based monomer. Preferred examples of the vinyl cyanide monomer include acrylonitrile and methacrylonitrile. Preferred examples of the methacrylate-based monomer include ethyl methacrylate, n-propyl methacrylate, isopropyl methacrylate, n-butyl methacrylate, isopropyl methacrylate, and tert-butyl methacrylate, and preferred examples of the acrylate-based monomer include methyl acrylate, ethyl acrylate, and butyl acrylate.

The aromatic vinyl-based polymer may be obtained by copolymerization of an additional copolymerizable monomer other than the above monomers. For example, a glycidyl group-containing vinyl-based monomer may be used for the copolymerization, and examples thereof include glycidyl methacrylate, glycidyl acrylate, vinyl glycidyl ether, allyl glycidyl ether, hydroxyalkyl (meth)acrylate glycidyl ether, polyalkylene glycol (meth)acrylate glycidyl ether, and glycidyl itaconate. The copolymerization amount of the glycidyl group-containing vinyl-based monomer is preferably 30% by mass or less, more preferably 20% by mass or less, and particularly preferably as small as about 10% by mass or less.

Among the above materials, a copolymer obtained by copolymerizing the styrene-based monomer and the vinyl cyanide monomer is preferable for the shell layer of the core/shell-type elastomer (C-2), and a styreneacrylonitrile-based copolymer is particularly preferred.

Preferably, the core layer and the shell layer of the core/shell-type elastomer (C-2) are generally graft-bonded to each other. The graft copolymerization is achieved by optionally adding a graft-linking agent reactable with the shell layer during the polymerization of the rubber layer to add reactive groups to the rubber layer and then forming the shell layer. The graft-linking agent is a compound having a vinyl bond. The above-described crosslinkable monomer can be used as the graft-linking agent for the acrylic-based rubber component. For the polyorganosiloxane-based rubber component, an organosiloxane having a vinyl bond or an organosiloxane including thiol is used. Preferably, any of (meth)acryloyloxyalkylsiloxanes and vinylsiloxanes that are organosiloxanes having a vinyl bond is used.

Among the (meth)acryloyloxyalkylsiloxanes, methacryloyloxyalkylsiloxanes are preferred, and specific examples thereof include β-methacryloyloxyethyldimethoxymethylsilane, γ-methacryloyloxypropylmethoxydimethylsilane, γ-methacryloyloxypropyldimethoxymethylsilane, γ-methacryloyloxypropyltrimethoxysilane, γ-methacryloyloxypropylethoxydiethoxysilane, γ-methacryloyloxypropyldiethoxymethylsilane, and δ-methacryloyloxybutyldiethoxymethylsilane.

Examples of the vinylsiloxane include vinylmethyldimethoxysilane and vinyltrimethoxysilane. Examples of mercaptosiloxane that is the organosiloxane including thiol include γ-mercaptopropyldimethoxymethylsilane, γ-mercaptopropyltrimethoxysilane, and γ-mercaptopropyldiethoxyethylsilane.

The content of the polyorganosiloxane-based rubber component in the core/shell-type elastomer (C-2) is preferably 2 to 30% by mass and more preferably 3 to 25% by mass. It is preferable that the content of the polyorganosiloxane-based rubber component is in the above range because alkali resistance and shock resistance tend to be improved.

Preferably, the average particle diameter of the core/shell-type elastomer (C-2) is 50 to 400 nm. It is preferable that the average particle diameter is in the above range because shock resistance, alkali resistance, heat shock resistance, moist heat resistance, and moldability tend to be improved. The range of the average particle diameter is more preferably 80 to 350 nm and particularly preferably 100 to 300 nm. In this range, it is expected that the most stable shock resistance, alkali resistance, and heat shock resistance may be obtained. The average diameter of the secondary particles of the core/shell-type elastomer (C-2) is preferably 600 to 3000 µm, more preferably 700 to 2000 µm, still more preferably 800 to 1700 µm, and particularly preferably 900 to 1500 µm. It is preferable that the average diameter of the secondary particles is as described above because the fine powder of the elastomer is unlikely to remain in a feed pipe and a hopper during melt kneading and because the elastomer can be stably fed.

The average particle diameter of the core/shell-type elastomer (C-2) is a value determined by observing the morphology of the resin composition, measuring the maximum diameters of at least 200 particles of the elastomer dispersion phase in the morphology observation results, and determining the arithmetic average of the diameters. The average diameter of the secondary particles is a value obtained by observing the core/shell-type elastomer (C-2) raw material under, for example, a microscope, measuring the maximum diameters of at least 200 particles, and determining the arithmetic average of the diameters.

A method for producing the core/shell-type elastomer is a known art, and methods disclosed in, for example, JP5-005055A, JP5-25377A, JP2000-290482A, and JP2001-261945A can be used. In the present invention also, a well-known method can be used. The polymerization can be performed using any of polymerization processes such as bulk polymerization, solution polymerization, suspension polymerization, and emulsion polymerization. The emulsion polymerization is easiest and is a preferred method.

The core/shell-type elastomer having the above-described average particle diameter can be obtained by subjecting a monomer including an aromatic vinyl monomer to emulsion graft polymerization in a single step or multiple steps in the presence of a composite rubber latex containing the polyorganosiloxane-based rubber component and the acrylic-based rubber component.

When the polybutylene terephthalate-based resin composition of the present invention contains the core/shell-type elastomer (C-2), its content is preferably in the range of 1 to 20 parts by mass, more preferably 3 to 17 parts by mass, and still more preferably in the range of 5 to 15 parts by mass based on 100 parts by mass of the resin (A). When the content is equal to or higher than the above lower limit, the effect of improving alkali resistance etc. can be obtained sufficiently. When the content is equal to or lower than the above upper limit, heat resistance and mechanical properties such as stiffness can be maintained.

### <(C-3) Core/shell-type elastomer including core layer containing polyorganosiloxane-based rubber component and acrylic-based rubber component and glycidyl-modified acrylate-based polymer placed on core layer>

The core/shell-type elastomer (C-3) is a core/shell-type elastomer (C-3) including the core layer containing the polyorganosiloxane-based rubber component and the acrylic-based rubber component and the glycidyl-modified acrylate-based polymer disposed on the core layer.

The rubber layer of the core/shell-type elastomer (C-3) must contain at least the polyorganosiloxane-based rubber component and the acrylic-based rubber component. The polyorganosiloxane-based rubber component and the acrylic-based rubber component for the rubber layer of the core/shell-type elastomer (C-2) are used for the rubber layer of the core/shell-type elastomer (C-3).

The shell layer of the core/shell-type elastomer (C-3) must contain at least the glycidyl-modified acrylate-based polymer.

The acrylate-based polymer is a homopolymer or a copolymer of acrylate or methacrylate.

Examples of the acrylate and the methacrylate include methyl acrylate, ethyl acrylate, propyl acrylate, butyl acrylate, pentyl acrylate, hexyl acrylate, heptyl acrylate, octyl acrylate, 2-ethylhexyl acrylate, and methyl, ethyl, propyl, butyl, octyl, 2-ethylhexyl, lauryl, and stearyl esters of methacrylic acid. One of them is used, or two or more of them are copolymerized.

Compounds obtained by copolymerization of vinyl monomers such as vinyl cyanide compounds and aromatic vinyl compounds can also be used. Examples of the vinyl cyanide compounds include acrylonitrile and methacrylonitrile, and examples of the aromatic vinyl compounds include styrene, α-methylstyrene, and methylstyrene.

A polymer obtained by polymerization of a small amount of a crosslinkable monomer is also preferable. Example of the crosslinkable monomer include: vinyl compounds such as butylene diacrylate, butylene dimethacrylate, ethylene glycol diacrylate, ethylene glycol dimethacrylate, butylene glycol diacrylate, butylene glycol dimethacrylate, oligoethylene glycol diacrylate, trimethylolpropane diacrylate, trimethylolpropane dimethacrylate, and trimethylolpropane trimethacrylate; and allyl compounds such as allyl acrylate, allyl methacrylate, diallyl maleate, diallyl fumarate, diallyl itanirate, monoallyl malate, monoallyl fumarate, and triallyl cyanurate.

The shell layer of the core/shell-type elastomer (C-3) must be glycidyl-modified. The glycidyl modification is performed by copolymerizing or graft-polymerizing a glycidyl group-containing vinyl-based monomer. Examples of the glycidyl group-containing vinyl-based monomer include glycidyl methacrylate, glycidyl acrylate, vinyl glycidyl ether, allyl glycidyl ether, hydroxyalkyl (meth)acrylate glycidyl ether, polyalkylene glycol (meth)acrylate glycidyl ether, and glycidyl itaconate.

The copolymerization amount of the glycidyl group-containing vinyl-based monomer is preferably 30% by mass or less, more preferably 20% by mass or less, and particularly preferably as small as about 10% by mass or less.

Preferably, the core layer and the shell layer of the core/shell-type elastomer (C-3) are generally graft-bonded to each other. A method for producing the core/shell-type elastomer is a known art as described above. The core/shell-type elastomer (C-3) can be produced by a known method.

When the polybutylene terephthalate-based resin composition of the present invention contains the core/shell-type elastomer (C-3), its content is preferably in the range of 1 to 10 parts by mass, more preferably 1.5 to 7 parts by mass, and still more preferably in the range of 2 to 5 parts by mass based on 100 parts by mass of the resin (A). When the content is equal to or higher than the above lower limit, the effect of improving alkali resistance etc. can be obtained sufficiently. When the content is equal to or lower than the above upper limit, heat resistance and mechanical properties such as stiffness can be maintained.

When the polybutylene terephthalate-based resin composition of the present invention contains all the above-described components (C-1), (C-2), and (C-3), the contents thereof are as follows. The mass ratio of the content of the component (C-1) to the content of the component (C-3), i.e., (C-1)/(C-3), is preferably 3.5/1 to 1/1 and, and the ratio (C-1)/(C-3) is more preferably 3/1 to 1/1.

The mass ratio of the component (C-2) to the component (C-3), i.e., (C-2)/(C-3), is preferably 5/1 to 1.2/1, and the ratio (C-2)/(C-3) is more preferably 4/1 to 2/1.

Moreover, the total content of the components (C-1), (C-2), and (C-3) is preferably 10 to 40 parts by mass based on 100 parts by mass of the resin (A). When the total content is equal to or higher than the above lower limit, the effect of improving alkali resistance etc. can be obtained sufficiently. When the content is equal to or lower than the above upper limit, heat resistance and mechanical properties such as stiffness can be maintained. The total content of the components (C-1), (C-2), and (C-3) is more preferably 13 to 35 parts by mass and still more preferably 15 to 30 parts by mass.

### <Flame retardant (D)>

The polybutylene terephthalate-based resin composition of the present invention may contain a flame retardant (D). When the flame retardant (D) is contained, the flame retardancy of the molded article can be improved.

Preferably, the flame retardant (D) is a bromine-based flame retardant because flame retardancy can be imparted using a small amount of the flame retardant (D) without deterioration in the characteristics of the resin. Preferred examples of the bromine-based flame retardant include brominated epoxy compounds, brominated polycarbonate compounds, brominated polystyrene compounds, and brominated acrylic compounds. Of these, the brominated epoxy compounds are suitable for the present invention because they have an epoxy group, which is a reactive functional group, so that the above-described effect of improving the plasma treatment effect can be obtained.

Preferred examples of the brominated epoxy compound include bisphenol A-type brominated epoxy compounds typified by a tetrabromo bisphenol A epoxy compound. Examples of the terminal end structure of the brominated epoxy compound include a phenyl group, a 4-t-butylphenyl group, and a 2,4,6-tribromophenyl group. In particular, a 2,4,6-tribromophenyl group may be present as a terminal end structure.

Polybrominated epoxy, i.e., a brominated phenolic resin, etc. is also used preferably.

Preferably, the terminals of the brominated epoxy compound are capped with tribromophenol. The epoxy equivalent of the brominated epoxy compound is preferably 3000 to 40000 g/eq, more preferably 4,000 to 35,000 g/eq, and particularly preferably 10,000 to 30,000 g/eq.

The brominated polycarbonate compound is preferably brominated bisphenol A and particularly preferably brominated polycarbonate obtained from tetrabromo bisphenol A. Examples of the terminal structure of the brominated polycarbonate compound include a phenyl group, a 4-t-butylphenyl group, and a 2,4,6-tribromophenyl group, and a brominated polycarbonate compound having a 2,4,6-tribromophenyl group as the terminal group structure is particularly preferable.

The average number of carbonate repeating units in the brominated polycarbonate compound may be appropriately selected and determined and is generally 2 to 30, preferably 3 to 15, and particularly preferably 3 to 10. If the average number of carbonate repeating units is small, a reduction in the molecular weight of the polybutylene terephthalate-based resin may occur during melting. If the average number is excessively large, the melt viscosity increases, and this may cause insufficient dispersion, so that the appearance of the molded article may deteriorate.

The brominated polystyrene may be produced by brominating polystyrene or polymerizing a brominated styrene monomer. The brominated polystyrene obtained by polymerizing brominated styrene is preferred because the amount of liberated bromine (atoms) is small.

The brominated polystyrene may be a copolymer obtained by copolymerization with another vinyl monomer. Examples of the vinyl monomer in this case include styrene, α-methylstyrene, acrylonitrile, methyl acrylate, butadiene, and vinyl acetate.

Specific examples of the brominated polystyrene include poly(4-bromostyrene), poly(2-bromostyrene), poly(3-bromostyrene), poly(2,4-dibromostyrene), poly(2,6-dibromostyrene), poly(2,5-dibromostyrene), poly(3,5-dibromostyrene), poly(2,4,6-tribromostyrene), poly(2,4,5-tribromostyrene), poly(2,3,5-tribromostyrene), poly(4-bromo-α-methylstyrene), poly(2,4-dibromo-a-methylstyrene), poly(2,5-dibromo-α-methylstyrene), poly(2,4,6-tribromo-α-methylstyrene), and poly(2,4,5-tribromo-α-methylstyrene). Poly(2,4,6-tribromostyrene), poly(2,4,5-tribromostyrene), and polydibromostyrene and polytribromostyrene having on average 2 to 3 bromine groups in the benzene ring are particularly preferably used.

Specific examples of the brominated acrylic compound include: homopolymers and copolymers of brominated polybenzyl (meth)acrylates such as poly(pentabromobenzyl (meth)acrylate); and homopolymers and copolymers of halogenated benzyl (meth)acrylates such as poly(pentachlorobenzyl (meth)acrylate). Brominated polybenzyl (meth)acrylate is preferably used.

The mass average molecular weight (Mw) of the bromine-based flame retardant is preferably 100 to 80,000 and particularly preferably 1,000 to 60,000. When the mass average molecular weight is equal to or higher than the above lower limit, bleedout from the molded article can be prevented. When the mass average molecular weight is equal to or lower than the above upper limit, a resin composition excellent in flowability can be obtained.

The mass average molecular weight (Mw) of the bromine-based flame retardant is a value (polystyrene equivalent value) measured by a GPC method (gel permeation chromatography).

The solvent used in the measurement for the brominated epoxy compound, the brominated polycarbonate compound, and the brominated polystyrene compound is THF (tetrahydrofuran), and the solvent used for the brominated acrylic compound is ODCB (o-dichlorobenzene). The column temperature during the measurement for the brominated epoxy compound, the brominated polycarbonate compound, and the brominated polystyrene compound is set to 40°C, and the column temperature during measurement for the brominated acrylic compound is set to 135°C.

The content of bromine atoms in the bromine-based flame retardant is preferably 1 to 90% by mass and particularly preferably 40 to 80% by mass. When the content of the bromine atoms is equal to or higher than the above lower limit, flame retardancy can be effectively improved, and the flame retardancy can be improved using a small amount of the bromine-based flame retardant.

The content of the bromine atoms in the bromine-based flame retardant is a value measured by ICP spectrometry, ion chromatography, X-ray fluorescence diffraction analysis, etc.

In the present invention, the flame retardant (D) used may be a phosphorus-based flame retardant such as phosphinate, a phosphazene compound, or a phosphate compound. These are each a compound having a phosphorus atom. Only one of them may be used, or a combination of two or more may be used.

Examples of the phosphinate include calcium salts and aluminum salts of phosphinic acid each having an anionic moiety represented by the following formula (1) or (2).

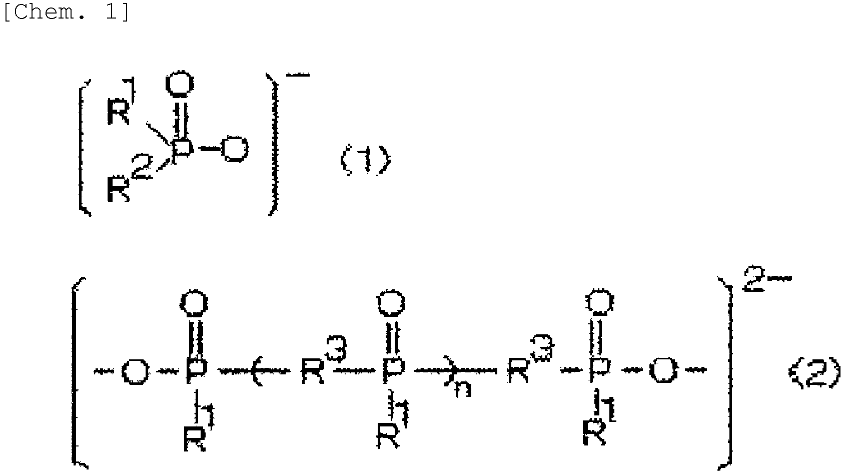

In the above formulas, R¹ and R² may be the same of different and each represent an alkyl group having 1 to 6 carbon atoms such as a methyl group, an ethyl group, an isopropyl group, a butyl group, or a pentyl group or an optionally substituted aryl group such as a phenyl group, an o-, m-, or p-methylphenyl group, a dimethylphenyl group, or an α- or β-naphthyl group. Preferably, R¹ and R² are each a methyl group or an ethyl group. R³ represents an alkylene group having 1 to 10 carbon atoms such as a methylene group, an ethylene group, a propylene group, a butylene group, or a 2-ethylhexylene group, an arylene group such as an o-, m-, or p-phenylene group, a 1,8-naphthylene group, or a 2,6-naphthylene group, or a mixed group of any two of above groups such as a methylenephenylene group or an ethylenephenylene group. R³ is preferably an alkylene group having 1 to 4 carbon atoms or a phenylene group.

Specific examples of the phosphinate include calcium dimethylphosphinate, aluminum dimethylphosphinate, calcium ethylmethylphosphinate, aluminum ethylmethylphosphinate, calcium diethylphosphinate, aluminum diethylphosphinate, calcium methyl-n-propylphosphinate, aluminum methyl-n-propylphosphinate, calcium methylphenylphosphinate, aluminum methylphenylphosphinate, calcium diphenylphosphinate, aluminum diphenylphosphinate, calcium methane bis (dimethylphosphinate), aluminum methane bis (dimethylphosphinate), calcium benzene-1,4-bis(dimethylphosphinate), and aluminum benzene-1,4-bis(dimethylphosphinate). Of these, aluminum diethylphosphinate is preferred in terms of flame retardancy and electric properties.

In terms of the appearance and mechanical strength of the molded resin article to be obtained, the phosphinate used is preferably a pulverized powder having a particle diameter of 100 µm or less and particularly preferably 50 µm or less as measured by a laser diffraction method. In particular, a pulverized powder having an average particle diameter of 0.5 to 20 µm is particularly preferable because high flame retardancy is obtained and the molded resin article can have significantly high strength. The phosphinate alone can function as a flame retardant. However, when a combination of the phosphinate and a nitrogen-based flame retardant such as a melamine cyanurate compound described later or a melamine phosphate compound is used, excellent flame retardancy and electric properties can be obtained even when the amount used is small.

The phosphazene compound can be any compound previously known as a resin flame retardant, and examples thereof include phosphazene compounds having structures described in James E. Mark, Harry R. Allcock, and Robert West, "Inorganic Polymers", Pretice-Hall International, Inc. 1992, p 61 to p 140, a cyclic phosphazene compound represented by the following formula (3), and a chain phosphazene compound represented by the following formula (4).

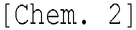

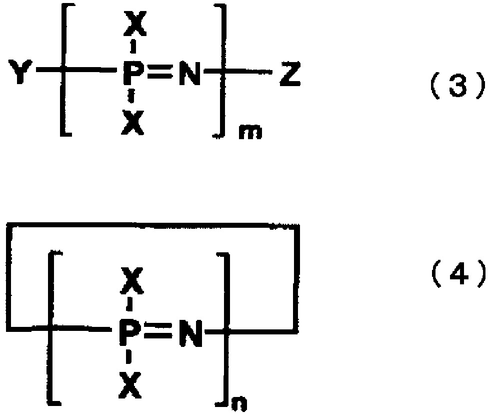

In formulas (3) and (4) above, n is an integer of 3 to 25, and m is an integer of 3 to 10000. Substituents X may be different from each other and are each selected from the group consisting of alkyl groups having 1 to 6 carbon atoms, aryl groups having 6 to 11 carbon atoms, a fluorine atom, a phenoxy group represented by the following formula (5) and having substituents, a naphthyloxy group, alkoxy groups having 1 to 6 carbon atoms, and alkoxy-substituted alkoxy groups. Any hydrogen atom in these substituents may be replaced with a fluorine atom, a hydroxy group, a cyano group, etc. Y in formula (3) represents -N=P(O)(X) or - N=P(X)₃, and Z represents -P(X)₄ or -P(O)(X)₂.

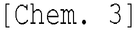

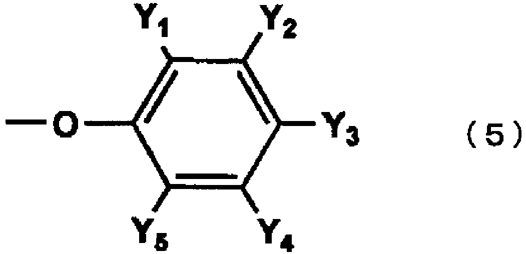

In formula (5) above, Y₁, Y₂, Y₃, Y₄, and Y₅ are each independently selected from the group consisting of a hydrogen atom, a fluorine atom, alkyl groups and alkoxy groups having 1 to 5 carbon atoms, a phenyl group, and heteroatom-containing groups.

One factor that determines the effect of the phosphazene compound as the flame retardant is the concentration of phosphorus atoms in one molecule. From this point of view, cyclic phosphazene compounds are generally preferable to chain phosphazene compounds having substituents at their molecular ends.

Specific examples of the substituents X in formulas (3) and (4) above include: alkyl groups such as a methyl group, an ethyl group, a n-propyl group, an isopropyl group, a s-butyl group, a tert-butyl group, a n-amyl group, and an isoamyl group; aryl groups such as a phenyl group and naphthyl group; alkyl-substituted aryl groups such as a 2-methylphenyl group, a 3-methylphenyl group, a 4-methylphenyl group, a 2,6-dimethylphenyl group, a 3,5-dimethylphenyl group, a 2,5-dimethylphenyl group, a 2,4-dimethylphenyl group, a 3,4-dimethylphenyl group, a 4-tert-butylphenyl group, and a 2-methyl-4-tert-butylphenyl group; alkoxy groups such as a methoxy group, an ethoxy group, a n-propyloxy group, an isopropyloxy group, a n-butyloxy group, a tert-butyloxy group, a s-butyloxy group, a n-amyloxy group, and a n-hexyloxy group; alkoxy-substituted alkoxy groups such as a methoxymethoxy group, a methoxyethoxy group, a methoxyethoxymethoxy group, a methoxyethoxyethoxy group, and a methoxypropyloxy group; alkyl- or aryl-substituted phenoxy groups such as a phenoxy group, a 2-methylphenoxy group, a 3-methylphenoxy group, a 4-methylphenoxy group, a 2,6-dimethylphenoxy group, a 2,5-dimethylphenoxy group, a 2,4-dimethylphenoxy group, a 3,5-dimethylphenoxy group, a 3,4-dimethylphenoxy group, a 2,3,4-trimethylphenoxy group, a 2,3,5-trimethylphenoxy group, a 2,3,6-trimethylphenoxy group, a 2,4,6-trimethylphenoxy group, a 2,4,5-trimethylphenoxy group, a 2-ethylphenoxy group, a 3-ethylphenoxy group, a 4-ethylphenoxy group, a 2,6-diethylphenoxy group, a 2,5-diethylphenoxy group, a 2,4-diethylphenoxy group, a 3,5-diethylphenoxy group, a 3,4-diethylphenoxy group, a 4-n-propylphenoxy group, a 4-tert-butylphenoxy group, a 2-phenylphenoxy group, and a 4-phenylphenoxy group; and a naphthyloxy group.

The phosphazene compound may be crosslinked by phenylene groups, biphenylene groups, or groups represented by the following formula (6) using a technique disclosed in WO2000/009518A1.

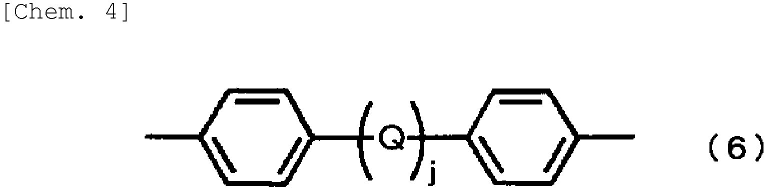

In the above formula, Q represents -C(CH₃)₂-, -SO₂-, -S-, or -O-, and j represents 0 or 1.

The phosphazene compound having any of these crosslinking structures can be produced, for example, by reacting a dichlorophosphazene oligomer with an alkali metal salt of phenol and an alkali metal salt of an aromatic dihydroxy compound. In this case, the amounts of these alkali metal salts used for the dichlorophosphazene oligomer are slightly larger than their theoretical values.

The phosphazene compound is generally a mixture of compounds having different structures including, for example, cyclic compounds such as a cyclic trimer and a cyclic tetramer, chain phosphazenes, and crosslinked compounds. When the content of the cyclic trimer, the cyclic tetramer, and the crosslinked compounds is high, the workability of a resin composition prepared tends to be high. Therefore, in the phosphazene compound used, the content of the cyclic trimer, the cyclic tetramer, and the crosslinked compounds is preferably 70% by mass or more and particularly preferably 80% by mass or more.

It is preferable that the content of cyclic and chain phosphazene compounds having a hydroxy group (i.e., having P-OH or an X-P(=O)NH- bond, which is its oxo form) is small and is generally less than 1% by mass.

It is preferable that, in the phosphazene compound, the content of alkali metals such as sodium and potassium is small, and the total content of alkali metals is preferably 50 ppm or less. It is also preferable that the content of chlorine is small, and the chlorine content is preferably 500 ppm of less and particularly preferably 300 ppm of less. In terms of electric properties, hydrolysis resistance, etc., the content of water is preferably 500 ppm of less and particularly preferably 300 ppm of less. The acid value j measured according to JIS K6751 is preferably 1.0 or less and particularly preferably 0.5 or less. In terms of hydrolysis resistance, water absorption resistance, etc., the solubility of the phosphazene compound in water (the amount of the phosphazene compound dissolved in distilled water when the sample is added to the distilled water at a concentration of 0.1 g/mL and the mixture is stirred at 25°C for 1 hour) is preferably 50 ppm of less and particularly preferably 25 ppm of less.

Examples of the phosphate compound used include esters of phosphoric acid with phenols or optionally substituted alcohols having 1 to 10 carbon atoms such as trimethyl phosphate, triethyl phosphate, tributyl phosphate, trioctyl phosphate, tributoxyethyl phosphate, triphenyl phosphate, tricresyl phosphate, cresyl diphenyl phosphate, and octyl diphenyl phosphate. Preferably, a (poly)ester of phosphoric acid and a hydroxy aromatic compound represented by the following formula (7) is used.

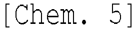

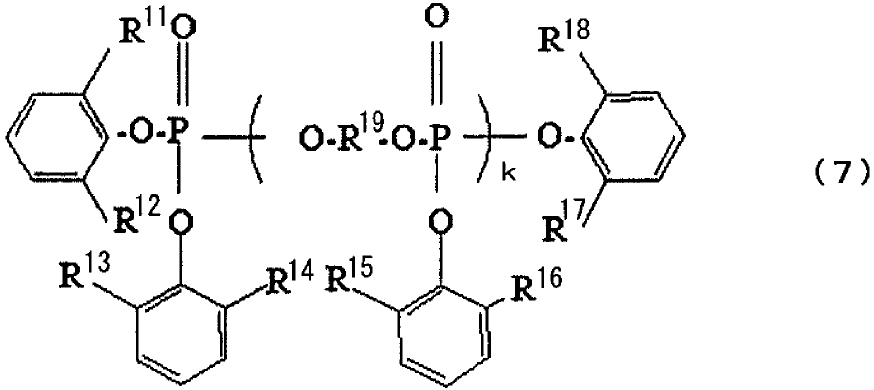

In formula (7) above, R¹¹ to R¹⁸ each independently represent a hydrogen atom or an alkyl group having 1 to 6 carbon atoms, and R¹⁹ represents a divalent group selected from a p-phenylene group, a m-phenylene group, a 4,4-biphenylene group, and the following formula (8). k represents an integer of 0 to 4.

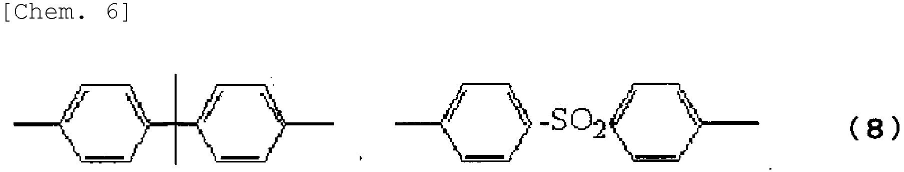

In formula (7) above, R¹ to R⁸ are each preferably an alkyl group having 6 or less carbon atoms, more preferably a methyl group or an ethyl group, and particularly preferably a methyl group. The hydrolysis resistance of a resin composition prepared using a phosphate compound in which R¹¹ to R¹⁸ are each a methyl group or an ethyl group is generally better than the hydrolysis resistance of resin compositions prepared using other phosphate compounds. R¹⁹ is preferably a m- or p-phenylene group and particularly preferably a m-phenylene group.

The polybutylene terephthalate-based resin composition of the present invention may contain, as the flame retardant (D), a salt of an amino group-containing triazine that is a nitrogen-based flame retardant. The amino group-containing triazine salt alone has the flame retardant effect, but the use of a combination of the amino group-containing triazine salt and a phosphinate improves the flame retardant effect significantly.

In the amino group-containing triazine salt serving as a nitrogen-based flame retardant, the amino group-containing triazine (a triazine having an amino group) used is generally an amino group-containing 1,3,5-triazine, and examples thereof include melamine, substituted melamines (such as 2-methylmelamine and guanylmelamine), melamine condensates (such as melam, melem, and melon), cocondensated resins of melamine (such as melamine-formaldehyde resins), amides of cyanuric acid (such as ammeline and ammelide), and guanamines and derivatives thereof (such as guanamine, methylguanamine, acetoguanamine, benzoguanamine, succinoguanamine, adipoguanamine, phthaloguanamine, and CTU-guanamine).

Examples of the salt include salts of the triazines and inorganic and organic acids. The inorganic acids include nitric acid, chloric acids (such as chloric acid and hypochlorous acid), phosphoric acids (such as phosphoric acid, phosphorous acid, hypophosphorous acid, and polyphosphoric acid), sulfuric acids (such as non-condensed sulfuric acids such as sulfuric acid and sulfurous acid and condensed sulfuric acids such as peroxydisulfuric acid and pyrosulfuric acid), boric acid, chromic acid, antimonic acid, molybdic acid, and tungstic acid. Of these, phosphoric acid and sulfuric acid are preferred. Examples of the organic acids include organic sulfonic acids (aliphatic sulfonic acids such as methanesulfonic acid, aromatic sulfonic acids such as toluenesulfonic acid and benzenesulfonic acid, etc.) and cyclic ureas (uric acid, barbituric acid, cyanuric acid, acetylene urea, etc.). Of these, alkanesulfonic acids having 1 to 4 carbon atoms such as methanesulfonic acid, arenesulfonic acids having 6 to 12 carbon atoms and substituted with an alkyl having 1 to 3 carbon atoms such as toluenesulfonic acid, and cyanuric acid are preferred.

Examples of the amino group-containing triazine salt include a melamine-melam-melem double salt of cyanuric acid, melamine phosphates (melamine polyphosphate, a melamine-melam-melem double salt of polyphosphoric acid, etc.), melamine sulfates (melamine sulfate, dimelamine sulfate, dimelam pyrosulfate, etc.), and melamine sulfonates (melamine methanesulfonate, melam methanesulfonate, melem methanesulfonate, a melamine-melam-melem double salt of methanesulfonic acid, melamine toluenesulfonate, melam toluenesulfonate, and a melamine-melam-melem double salt of toluenesulfonic acid). Any of these amino group-containing triazine salts may be used alone, or a combination of two or more may be used.

Among the above nitrogen-based flame retardants, an adduct of cyanuric acid or isocyanuric acid with a triazine-based compound is preferably used in the present invention. The adduct generally has a composition of 1:1 (molar ratio) and occasionally 1:2 (molar ratio). The adduct is more specifically melamine cyanurate, benzoguamine cyanurate, or acetoguanamine cyanurate and yet more specifically melamine cyanurate. These salts are generally produced by well-known methods. For example, a mixture of a triazine-based compound and cyanuric acid or isocyanuric acid is used to form an aqueous slurry, and the triazine-based compound and the cyanuric acid or isocyanuric acid are well-mixed to form their salt as fine particles. Then the slurry is filtered, and the residue is dried to obtain a powder. It is unnecessary that the salt be completely pure, and a small amount of the unreacted triazine-based compound and cyanuric acid or isocyanuric acid may remain present.

In terms of the flame retardancy, mechanical strength, moist heat resistance, retention stability, surface characteristics, etc. of the molded resin article to be obtained, the particle diameter of the amino group-containing triazine salt is preferably 100 µm or less as measured by a laser diffraction method, and the average particle diameter is particularly preferably 1 to 80 µm. When the dispersiveness of the amino group-containing triazine salt is poor, a dispersant such as tris(β-hydroxyethyl)isocyanurate and a well-known surface treatment agent may be used in combination.

When the polybutylene terephthalate-based resin composition of the present invention contains the flame retardant (D), its content is preferably 0.01 to 100 parts by mass, more preferably 0.1 to 80 parts by mass, and still more preferably 1 to 70 parts by mass based on 100 parts by mass of the resin (A). When the content of the flame retardant (D) is equal to or higher than the above lower limit, sufficient flame retardancy can be obtained. When the content is equal to or lower than the above upper limit, problems such as a reduction in mechanical properties, a reduction in releasability, and bleedout of the flame retardant that are caused by an excessive amount of the flame retardant added can be prevented.

### <Antimony compound (E)>

When the polybutylene terephthalate-based resin composition of the present invention contains the flame retardant (D), it is preferable that an antimony compound (E) is further contained as a flame retardant aid. Examples of the antimony compound (E) include antimony trioxide (Sb₂O₃), antimony pentoxide (Sb₂O₅), and sodium antimonate. In particular, antimony trioxide is preferred in terms of shock resistance.

The content of the antimony compound (E) is preferably 5 to 15 parts by mass, more preferably 7 to 13 parts by mass, and still more preferably 8 to 12 parts by mass based on 100 parts by mass of the resin (A). When the content of the antimony compound (E) is equal to or higher than the above lower limit, sufficient flame retardancy can be obtained. When the content is equal to or lower than the above upper limit, a reduction in mechanical strength can be prevented.

In the polybutylene terephthalate-based resin composition of the present invention, the total mass concentration of bromine atoms originating from the bromine-based flame retardant (D) and antimony atoms originating from the antimony compound (E) is preferably 3 to 25% by mass, more preferably 4 to 22% by mass, still more preferably 5 to 20% by mass, and particularly preferably 10 to 20% by mass. When the concentration is equal to or higher than the above lower limit, sufficient flame retardancy can be obtained. When the concentration is equal to or lower than the above upper limit, a reduction in mechanical strength can be prevented. The mass ratio of the bromine atoms to the antimony atoms (Br/Sb) is preferably 0.3 to 5 and more preferably 0.3 to 4. The mass ratio in the above range is preferred because flame retardancy tends to be obtained.

In the present invention, a masterbatch of the antimony compound (E) may be used. In a preferred mode, a masterbatch of the antimony compound (E) and a thermoplastic resin, preferably polybutylene terephthalate resin, is added. In this case, the antimony compound (E) can be easily present in the resin (A) phase. Therefore, thermal stability during melt kneading and molding is improved, so that a reduction in shock resistance is prevented. Moreover, unevenness in flame retardancy and unevenness in shock resistance tend to be reduced.

The content of the antimony compound (E) in the masterbatch is preferably 20 to 90% by mass. When the content of the antimony compound (E) is equal to or higher than the above lower limit, the ratio of the antimony compound in the flame retardant masterbatch is sufficient, so that the flame retardancy improving effect of the flame retardant masterbatch added can be obtained sufficiently. When the content of the antimony compound (E) is equal to or lower than the above upper limit, the dispersibility of the antimony compound (E) is high. In this case, flame retardancy is easily obtained, and workability when the masterbatch is produced is high, so that strands produced when an extruder is used can be stabilized.

The content of the antimony compound (E) in the masterbatch is more preferably 20 to 85% by mass and still more preferably 25 to 80% by mass.

### <Reinforcement material (F)>

Preferably, the polybutylene terephthalate-based resin composition of the present invention contains a reinforcement material (F).

In the present invention, the reinforcement material (F) is a material to be contained in a resin to improve its strength and stiffness and may be in a fiber form, a plate form, a particle form, an amorphous form, etc.

When the reinforcement material (F) is in the form of fibers, the reinforcement material (F) may be either an inorganic material or an organic material. Examples thereof include: inorganic fibers such as glass fibers, carbon fibers, silica-alumina fibers, zirconia fibers, boron fibers, boron nitride fibers, silicon nitride potassium titanate fibers, metal fibers, and wollastonite; and organic fibers such as fluorocarbon resin fibers and aramid fibers. When the reinforcement material (F) is in the form of fibers, inorganic fibers are preferred, and glass fibers are particularly preferred. One reinforcement material (F) may be used, or a mixture of two or more may be used.

When the reinforcement material (F) is in the form of fibers, no particular limitation is imposed on the average fiber diameter thereof, the average fiber length thereof, and the cross-sectional shape thereof. The average fiber diameter is preferably in the range of, for example, 1 to 100 µm, and the average fiber length is preferably in the range of, for example, 0.1 to 20 mm. The average fiber diameter is more preferably about 1 to about 50 µm and still more preferably about 5 to about 20 µm. The average fiber length is preferably about 0.12 to about 10 mm. When the cross section of the fibers has a flattened shape such as an oval shape, an elliptical shape, or an egg shape, its aspect ratio (the ratio of the major axis/the minor axis) is preferably 1.4 to 10, more preferably 2 to 6, and still more preferably 2.5 to 5. The use of glass fibers having such an irregular shape is preferred because the dimensional stability of the molded article such as warpage and anisotropy in shrinkage ratio tends to be improved.

A plate-shape, particulate, or amorphous reinforcement material other than the above fibrous reinforcement material may be contained. A plate-shaped inorganic filler has the function of reducing anisotropy and warpage, and examples thereof include glass flaks, talc, mica, isinglass, kaolin, and metal foils. Of these plate-shaped inorganic fillers, glass flakes are preferred.

Examples of the particulate and amorphous inorganic fillers include ceramic beads, asbestos, clay, zeolite, potassium titanate, barium sulfate, titanium oxide, silicon oxide, aluminum oxide, and magnesium hydroxide.

To improve the adhesion at the interface between the reinforcement material (F) and the resin components, it is preferable to treat the surface of the reinforcement material (F) with a surface treatment agent such as a sizing agent. Examples of the surface treatment agent include epoxy resins, acrylic resins, urethane resins, and functional compounds such as isocyanate-based compounds, silane-based compounds, and titanate-based compounds.

In the present invention, it is preferable to use an epoxy resin for the surface treatment. When the epoxy resin having epoxy groups serving as reactive functional groups is used, the effect of improving the above-described plasma treatment effect can be obtained. The epoxy resin is preferably a novolac-type epoxy resin such as a phenol novolac-type or cresol novolac-type epoxy resin or a bisphenol A-type epoxy resin. In particular, a combination of a novolac-type epoxy resin and a bisphenol-type epoxy resin is preferably used, and a combination of a phenol novolac-type epoxy resin and a bisphenol A-type epoxy resin is preferably used in terms of alkali resistance, hydrolysis resistance, and mechanical properties.

The functional compound is preferably, for example, an aminosilane-based, epoxysilane-based, allylsilane-based, or vinylsilane-based silane coupling agent. In particular, an aminosilane-based compound is preferred.

Preferred examples of the aminosilane-based compound include γ-aminopropyltriethoxysilane, γ-aminopropyltrimethoxysilane, γ-glycidoxypropyltrimethoxysilane, and γ-(2-aminoethyl)aminopropyltrimethoxysilane. In particular, γ-aminopropyltriethoxysilane and γ-glycidoxypropyltrimethoxysilane are preferred.

In the present invention, it is particularly preferable, in terms of alkali resistance and hydrolysis resistance, that the reinforcement material (F) used is subjected to surface treatment with a novolac-type epoxy resin and a bisphenol-type epoxy resin used as the sizing agent and also with the aminosilane-based coupling agent used as the coupling agent. In the above-described surface treatment agents, the inorganic functional groups in the aminosilane-based compound are highly reactive with the surface of the reinforcement material (F), and the organic functional groups in the aminosilane are highly reactive with the glycidyl groups in the epoxy resin. Moreover, the glycidyl groups in the epoxy resin suitably react with the polybutylene terephthalate resin, so that the adhesion at the interface between the reinforcement material (F) and the epoxy resin is improved. When the polyamide resin is used, its dispersibility tends to be improved. Therefore, the alkali resistance, hydrolysis resistance, and mechanical properties of the polybutylene terephthalate-based resin composition of the present invention may tend to be improved.

The surface treatment agent may contain a urethane resin, an acrylic resin, an antistatic agent, a lubricant, a water-repellent, etc. so long as the spirit of the invention is maintained. When any of these additional components is contained, it is preferable to use the urethane resin.

The reinforcement material (F) can be subjected to surface treatment using a well-known conventional method. For example, the reinforcement material (F) may be subjected to surface treatment with any of the above surface treatment agents in advance. Alternatively, before the polybutylene terephthalate-based resin composition of the present invention is prepared, a surface treatment agent may be added separately from the untreated reinforcement material (F) to perform surface treatment.

The amount of the surface treatment agent adhering to the reinforcement material (F) is preferably 0.01 to 5% by mass and more preferably 0.05 to 2% by mass. An amount of 0.01% by mass or more is preferred because the mechanical strength tends to be improved more effectively. An amount of 5% by mass or less is preferred because a necessary and sufficient effect is obtained and the resin composition tends to be produced easily.

When the polybutylene terephthalate-based resin composition of the present invention contains the reinforcement material (F), its content is preferably 30 to 100 parts by mass based on 100 parts by mass of the resin (A). When the content of the reinforcement material (F) is equal to or higher than the above lower limit, the above-described effect of the reinforcement material (F) added can be obtained sufficiently. When the content is equal to or lower than the above upper limit, the flowability and moldability of the resin composition may not deteriorate. The content of the reinforcement material (F) is more preferably 40 parts by mass or more and still more preferably 50 parts by mass or more and is more preferably 90 parts by mass or less and still more preferably 80 parts by mass or less.

### <Release agent (G)>

The polybutylene terephthalate-based resin composition of the present invention may contain a release agent (G) in order to obtain good mold releasability during molding.

Any previously known release agent generally used for polyester resins can be used as the release agent (G). In particular, at least one release agent selected from polyolefin-based compounds, aliphatic ester-based compounds, and silicone-based compounds is preferred because good alkali resistance is obtained, and the polyolefin-based compounds are particularly preferable.

The polyolefin-based compounds are compounds selected from paraffin wax and polyethylene wax. A polyolefin-based compound having a mass average molecular weight of 700 to 10,000 is preferred, and the mass average molecular weight is more preferably 900 to 8,000.

Examples of the aliphatic ester-based compounds include aliphatic esters such as saturated and unsaturated monovalent and divalent aliphatic carboxylates, glycerin aliphatic esters, and sorbitan aliphatic esters and partially saponified products thereof. Of these, mono and dialiphatic esters prepared from alcohols and aliphatic acids having 11 to 28 carbon atoms, preferably 17 to 21 carbon atoms, are preferred.

Examples of the aliphatic carboxylic acid include palmitic acid, stearic acid, caproic acid, capric acid, lauric acid, arachic acid, behenic acid, lignoceric acid, cerotic acid, melissic acid, tetrariacontanoic acid, montanic acid, adipic acid, and azelaic acid. The aliphatic carboxylic acid may be an alicyclic carboxylic acid.

Examples of the alcohol include saturated and unsaturated monohydric and polyhydric alcohols. These alcohols may have substituents such as a fluorine atom and aryl groups. Of these, saturated monohydric and polyhydric alcohols having 30 or less carbon atoms are preferred, and saturated aliphatic monohydric and polyhydric alcohols having 30 or less carbon atoms are more preferred. The term "aliphatic" is intended to encompass alicyclic.

Specific examples of the alcohol include octanol, decanol, dodecanol, stearyl alcohol, behenyl alcohol, ethylene glycol, diethylene glycol, glycerin, pentaerythritol, 2,2-dihydroxyperfluoropropanol, neopentyl glycol, ditrimethylolpropane, and dipentaerythritol.

The above aliphatic ester-based compound may contain, as impurities, an aliphatic carboxylic acid and/or an alcohol and may be a mixture of a plurality of compounds.

Specific examples of the aliphatic ester based compound include glycerin monostearate, glycerin monobehenate, glycerin dibehenate, glycerin-12-hydorxymonostearate, sorbitan monobehenate, pentaerythritol monostearate, pentaerythritol distearate, stearyl stearate, and ethylene glycol montanate.

The silicone-based compound is preferably a modified compound because of the compatibility with the polybutylene terephthalate resin etc. Examples of a modified silicone oil include a silicone oil in which an organic group is introduced into a side chain of the polysiloxane and a silicone oil in which an organic group is intruded into one end and/or both ends of the polysiloxane. Examples of the introduced organic group include an epoxy group, an amino group, a carboxyl group, a carbinol group, a methacrylic group, a mercapto group, and a phenol group, and an epoxy group is preferred. The modified silicone oil is particularly preferably a silicone oil in which an epoxy group is introduced into a side chain of the polysiloxane.

When the polybutylene terephthalate-based resin composition of the present invention contains the release agent (G), its content is preferably 0.1 to 3 parts by mass, more preferably 0.2 to 2.5 parts by mass, and still more preferably 0.5 to 2 parts by mass based on 100 parts by mass of the resin (A). When the content of the release agent is equal to or higher than the above lower limit, mold releasability during melt molding is improved, and the molded article can have good surface characteristics. When the content is equal to or lower than the above upper limit, a reduction in kneading workability of the resin composition is prevented, and other problems such as a reduction in hydrolysis resistance and contamination of a mold during injection molding that are caused by an excessive amount of the release agent added can be prevented.

### <Stabilizer (H)>

Preferably, the polybutylene terephthalate-based resin composition of the present invention further contains a stabilizer (H) because the effects of improving thermal stability and preventing deterioration in mechanical strength, transparency, and hue can be obtained. The stabilizer is preferably a phosphorus-based stabilizer or a phenol-based stabilizer.

Examples of the phosphorus-based stabilizer include phosphorous acid, phosphoric acid, phosphorous acid esters (phosphites), trivalent phosphoric acid esters (phosphonites), and pentavalent phosphoric acid esters (phosphates). Of these, phosphites, phosphonites, and phosphates are preferred.

Examples of the phosphites include triphenyl phosphite, tris(nonylphenyl)phosphite, dilauryl hydrogen phosphite, triethyl phosphite, tridecyl phosphite, tris(2-ethylhexyl)phosphite, tris(tridecyl)phosphite, tristearyl phosphite, diphenyl monodecyl phosphite, monophenyl didecyl phosphite, diphenyl mono(tridecyl)phosphite, tetraphenyl dipropylene glycol diphosphite, tetraphenyl tetra(tridecyl)pentaerythritol tetraphosphite, hydrogenated bisphenol A phenol phosphite polymers, diphenyl hydrogen phosphite, 4,4'-butylidene-bis(3-methyl-6-tert-butylphenyl di(tridecyl)phosphite), tetra(tridecyl)4,4'-isopropylidene diphenyl diphosphite, bis(tridecyl)pentaerythritol diphosphite, bis(nonylphenyl)pentaerythritol diphosphite, dilauryl pentaerythritol diphosphite, distearyl pentaerythritol diphosphite, tris(4-tert-butylphenyl)phosphite, tris(2,4-di-tert-butylphenyl)phosphite, hydrogenated bisphenol A pentaerythritol phosphite polymers, bis(2,4-di-tert-butylphenyl)pentaerythritol diphosphite, bis(2,6-di-tert-butyl-4-methylphenyl)pentaerythritol diphosphite, 2,2'-methylenebis(4,6-di-tert-butylphenyl)octyl phosphite, and bis(2,4-dicumylphenyl)pentaerythritol diphosphite.

Examples of the phosphonites include tetrakis(2,4-di-iso-propylphenyl)-4,4'-biphenylene diphosphonite, tetrakis(2,4-di-n-butylphenyl)-4,4'-biphenylene diphosphonite, tetrakis(2,4-di-tert-butylphenyl)-4,4'-biphenylene diphosphonite, tetrakis(2,4-di-tert-butylphenyl)-4,3'-biphenylene diphosphonite, tetrakis(2,4-di-tert-butylphenyl)-3,3'-biphenylene diphosphonite, tetrakis(2,6-di-iso-propylphenyl)-4,4'-biphenylene diphosphonite, tetrakis(2,6-di-n-butylphenyl)-4,4'-biphenylene diphosphonite, tetrakis(2,6-di-tert-butylphenyl)-4,4'-biphenylene diphosphonite, tetrakis(2,6-di-tert-butylphenyl)-4,3'-biphenylene diphosphonite, and tetrakis(2,6-di-tert-butylphenyl)-3,3'-biphenylene diphosphonite.

Examples of the phosphates include methyl acid phosphate, ethyl acid phosphate, propyl acid phosphate, isopropyl acid phosphate, butyl acid phosphate, butoxyethyl acid phosphate, octyl acid phosphate, 2-ethylhexyl acid phosphate, decyl acid phosphate, lauryl acid phosphate, stearyl acid phosphate, oleyl acid phosphate, behenyl acid phosphate, phenyl acid phosphate, nonylphenyl acid phosphate, cyclohexyl acid phosphate, phenoxyethyl acid phosphate, alkoxy polyethylene glycol acid phosphate, bisphenol A acid phosphate, dimethyl acid phosphate, diethyl acid phosphate, dipropyl acid phosphate, diisopropyl acid phosphate, dibutyl acid phosphate, dioctyl acid phosphate, di-2-ethylhexyl acid phosphate, dioctyl acid phosphate, dilauryl acid phosphate, distearyl acid phosphate, diphenyl acid phosphate, and bisnonylphenyl acid phosphate.

The phosphate used is preferably, for example, a mixture of monostearyl acid phosphate and distearyl acid phosphate (such as "ADK STAB AX-71" used in an Example).

Only one phosphorus-based stabilizer may be contained, or a combination of any two or more at any ratio may be contained.

Specific examples of the phenol-based stabilizer include pentaerythritol tetrakis[3-(3,5-di-tert-butyl-4-hydroxyphenyl)propionate], octadecyl-3-(3,5-di-tert-butyl-4-hydroxyphenyl)propionate, thiodiethylene bis[3-(3,5-di-tert-butyl-4-hydroxyphenyl)propionate], N,N'-hexane-1,6-diyl bis[3-(3,5-di-tert-butyl-4-hydroxyphenyl)propionamide], 2,4-dimethyl-6-(1-methylpentadecyl)phenol, diethyl[[3,5-bis(1,1-dimethylethyl)-4-hydroxyphenyl]methyl]phosphonate, 3,3',3'',5,5',5''-hexa-tert-butyl-a,a',a''-(mesitylene-2,4,6-triyl)tri-p-cresol, 4,6-bis(octylthiomethyl)-o-cresol, ethylene bis(oxyethylene)bis[3-(5-tert-butyl-4-hydroxy-m-tolyl)propionate], hexamethylene bis[3-(3,5-di-tert-butyl-4-hydroxyphenyl)propionate], 1,3,5-tris(3,5-di-tert-butyl-4-hydroxybenzyl)-1,3,5-triazine-2,4,6(1H,3H,5H)-trione, and 2,6-di-tert-butyl-4-(4,6-bis(octylthio)-1,3,5-triazine-2-ylamino)phenol.

Of these, pentaerythritol tetrakis[3-(3,5-di-tert-butyl-4-hydroxyphenyl)propionate] (such as "Irganox 1010" used in an Examples) and octadecyl-3-(3,5-di-tert-butyl-4-hydroxyphenyl)propionate are preferred.

One of the phenol-based stabilizers may be contained, or a combination of any two or more at any ratio may be contained.

When the polybutylene terephthalate-based resin composition of the present invention contains the stabilizer (H), its content is generally 0.001 parts by mass or more and preferably 0.01 parts by mass or more based on 100 parts by mass of the resin (A) and is generally 1.5 parts by mass or less and preferably 1 part by mass or less. When the content of the stabilizer (H) is equal to or higher than the above lower limit, the effect of the stabilizer (H) can be obtained sufficiently. When the content is equal to or lower than the above upper limit, the occurrence of silver streaks and deterioration in hue that are caused by an excessive amount of the stabilizer (H) added can be prevented.

### <Additional components>

The polybutylene terephthalate-based resin composition of the present invention may further contain various additives so long as the effects of the invention are not impaired. Examples of the additives include an anti-dripping agent, an ultraviolet absorber, pigments and dyes, a fluorescent brightening agent, an antistatic agent, an antifogging agent, a lubricant, an antiblocking agent, a flowability improver, a plasticizer, a dispersant, and an antimicrobial agent.

### [Polycarbonate-based resin composition]

When the resin composition of the present invention is the polycarbonate-based resin composition containing the polycarbonate resin as a main component of the resin (A), the resin composition may contain, in addition to the resin (A), various additives such as a stabilizer, a release agent, an ultraviolet absorber, a flame retardant, an anti-dripping agent, an antistatic agent, an antifogging agent, a lubricant, an antiblocking agent, a plasticizer, a dispersant, a flowability improver, an antimicrobial agent, and a coloring agent. Specific examples of the additives include the epoxy compound (B), the elastomer (C), the flame retardant (D), the antimony compound (E), the reinforcement material (F), the release agent (G), and the stabilizer (H) exemplified in the description of the polybutylene terephthalate-based resin composition of the present invention. Their preferred contents are the same as those for the polybutylene terephthalate-based resin composition of the present invention.

### [Method for producing resin composition]

One example of the method for producing the resin composition of the present invention is a method including well-mixing its components and various additives optionally added and melt-kneading the mixture using a single or twin screw extruder. Alternatively, the resin composition of the present invention can be produced as follows. Some of the components are mixed in advance, but the components may not be mixed in advance. Then the components are supplied to an extruder using a feeder, and then the mixture is melt kneaded. Alternatively, the resin composition may be produced as follows. Part of a component is added to part of the resin (A), and the mixture is melt-kneaded to prepare a masterbatch. Then the rest of the resin (A) and the other components are mixed with the masterbatch, and the mixture is melt-kneaded. When the reinforcement material (F) used is a fibrous material such as glass fibers, it is preferable to supply the reinforcement material (F) from a side feeder disposed at an intermediate point of a cylinder of the extruder.

As described above, it is preferable, in terms of thermal stability during melt kneading, molding, etc., flame retardancy, unevenness in shock resistance, etc., that a masterbatch of the antimony compound (E) prepared in advance is used. No particular limitation is imposed on the method for preparing the masterbatch, and one example is a method including melt-kneading the resin (A), preferably the resin (A) and the antimony compound, using a kneader such as a twin screw extruder. When the masterbatch is prepared, various additives such as a stabilizer may be optionally added.

The temperature of the melt of the resin composition during melt-kneading is preferably 180 to 350°C and more preferably 190 to 320°C. A temperature of the melt of lower than 180°C is not preferred because the melting is insufficient, and a large amount of unmolten gel tends to be formed. A temperature of the melt of 350°C or higher is not preferred because the resin composition is thermally degraded and is likely to be colored.

### [Molding of resin composition]

No particular limitation is imposed on the method for molding the resin composition of the present invention, and any molding method generally used for resin compositions can be used. Examples thereof include an injection molding method, an ultra-high-speed injection molding method, an injection compression molding method, a coinjection molding method, a blow molding method such as a gas-assisted blow molding method, a molding method using an insulated mold, a molding method using a rapid heating mold, foam molding (including supercritical fluid), insert molding, an IMC (in-mold coating molding) molding method, an extrusion molding method, a sheet forming method, a thermoforming method, a rotational molding method, a laminate molding method, a press forming method, and a blow molding method. Of these, an injection molding method is preferred.

The content of water in the resin composition at the time of injection molding is preferably 300 ppm of less and more preferably 100 ppm of less. If the water content exceeds 300 ppm, voids are likely to be generated in a boss portion. One problem that may occur in this case is that, for example, the strength of the boss portion is likely to decrease.

No particular limitation is imposed on the shape of the molded article of the present invention, and the shape is appropriately designed according to the intended use of the molded article . A surface on which the metal film is to be formed in the present invention may be a flat surface and may be a curved surface.

### [Applications]

No particular limitation is imposed on the application of the metal film-coated molded resin article of the present invention. The metal film formed on the metal film-coated molded resin article can be used as a seed layer, and a metal film of about 1 to about 50 µm can be formed on the seed layer by ordinary electroplating. Therefore, the metal film-coated molded resin article of the present invention can be effectively used for the purpose of imparting various functions such as decoration, corrosion resistance, abrasion resistance, solderability, electrical conductivity, electromagnetic wave shielding properties, magnetic properties, and heat resistance to the molded resin articles.

A plating film-coated molded article of the present invention including a plating layer formed on the metal film of the metal film-coated molded resin article of the present invention is useful, for example, for inner structures and casings of portable electronic device components, specifically electronic notepads, personal digital assistants such as mobile computers, pagers, mobile phones, and PHS phones. The plating film-coated molded article of the present invention is also useful for inner structures and casings of electrical components of vehicle-mounted components such as millimeter wave radars, ECUs, vehicle-mounted cameras, inverters, and PCUs.

### EXAMPLES

The present invention will next be described more specifically using Examples. However, the present invention is not to be construed as limited to the following Examples.

In the following description, the term "parts" represents "parts by mass" based on mass, unless otherwise specified.

Components used in the following Examples and Comparative Examples are as shown in Tables 1 and 2.

**[Table 1]**

| Component | Abbreviation | |
|---|---|---|
| Resin (A) | A1 | Polybutylene terephthalate |
| | | Manufactured by Mitsubishi Engineering-Plastics Corporation Product name: NOVADURAN (registered trademark) 5008 |
| | | Intrinsic viscosity: 0.85 dL/g |
| | A2 | Polyamide 6 resin Manufactured by Ube Industries, Ltd., Product name: UBE NYLON 1010X1 Viscosity number: 80 mL/g |
| Epoxy compound (B) | B1 | Bisphenol A-type epoxy compound Manufactured by ADEKA CORPORATION, Product name: EP-17 Epoxy equivalent: 185 g/eq |
| | | Mass average molecular weight: 370 |
| | B2 | Bisphenol A-diglycidyl ether-type epoxy compound Manufactured by Mitsubishi Chemical Corporation Product name: EPIKOTE 1003 |
| | | Epoxy equivalent: about 670-770 g/eq |
| | | Mass average molecular weight: 1300 |
| Elastomer (C) | C1 | Ethylene-glycidyl methacrylate-butyl acrylate copolymer Manufactured by DUPONT-MITSUI POLYCHEMICALS Co., Ltd. |
| | | Product name: ELVALOY AS |
| | | Ethylene content: 65% by mass |
| | | Glycidyl methacrylate content: 6% by mass |
| | | Butyl acrylate content: 29% by mass |
| | | MFR (190°C, 2.16 kg): 12 g/10 min |
| | C2 | Aromatic vinyl-based core/shell-type elastomer (core/shell-type graft copolymer composed of polydimethylsiloxane-polybutyl acrylate (core)/ styrene-acrylonitrile copolymer (shell)) Manufactured by Mitsubishi Chemical Corporation, Product name: METABLEN SRK200A |
| | | Average particle diameter: 250 nm |
| | | Average secondary particle diameter: 1320 µm |
| | | Content of siloxane rubber component in elastomer: 21% by mass |
| | C3 | Glycidyl-modified acrylate core/shell-type elastomer (core/shell-type graft copolymer composed of polydimethylsiloxane-polybutyl acrylate (core)/ glycidyl group-modified polymethyl methacrylate copolymer (shell)) Manufactured by Mitsubishi Chemical Corporation, Product name: METABLEN S-2200 |
| | | Content of siloxane rubber component in elastomer: 6% by mass |

**[Table 2]**

| Component | Abbreviation | |
|---|---|---|
| Flame retardant (D) | D1 | Polybrominated epoxy |
| | | Manufactured by Sakamoto Yakuhin Kogyo Co., Ltd., Product name: SR-T5000 Bromine atom content: 52% by mass |
| | | Mass average molecular weight: 20,000 |
| | | Epoxy equivalent: 5000 g/eq |
| Antimony compound (E) | E1 | Antimony trioxide |
| | | Manufactured by SUZUHIRO CHEMICAL CO., LTD., |
| | | Product name: Fire Cut AT-3CN |
| Reinforcement material (F) | F1 | Glass fibers treated with novolac epoxy resin |
| | | Manufactured by Nippon Electric Glass Co., Ltd., Product name: T-127 |
| | | Average fiber diameter: 13.5 µmm |
| | | Number average fiber length: 3 mm |
| Polyolefin-based release agent (G) | G1 | Microcrystalline wax Manufactured by Nippon Seiro Co., Ltd., Product name: Himic1080 |
| | | Number of carbon atoms: 30-60 |
| | | Dropping point: 84°C |
| Stabilizer (H) | H1 | Phenol-based stabilizer (Pentaerythritol tetrakis[3-(3,5-di-tert-butyl-4-hydroxyphenyl)propionate]) Manufactured by BASF, Product name: Irganox 1010 |
| Carbon black (I) | I1 | Carbon black masterbatch using polybutylene terephthalate resin base Manufactured by Mitsubishi Engineering-Plastics Corporation |
| | | Product name: RCB-30 |
| | | Carbon black content: 20% by mass |

### [Production of molded polybutylene terephthalate resin articles]

Components shown in Tables 1 and 2 except for the reinforcement material (F) were blended at one of ratios (all based on parts by mass) shown in Table 3. The mixture was melt-kneaded using a 30 mm vent-type twin screw extruder (twin screw extruder TEX30α manufactured by The Japan Steel Works, Ltd.) at a barrel temperature of 270°C while the glass fibers used as the reinforcement material (F) were fed through a side feeder. Then the mixture was extruded into strands and pelletized using a strand cutter. Pellets R1 to R4 of the polybutylene terephthalate-based resin composition were thereby obtained.

The pellets R1 to R4 obtained were dried at 110°C for 5 hours and injection-molded using an injection molding apparatus ("J85AD" manufactured by The Japan Steel Works, Ltd.) under the conditions of a cylinder temperature of 250°C and a mold temperature of 80°C, and plate-shaped molded articles R1 to R4 with 100 mm × 100 mm × 3 mm thickness were thereby obtained.

**[Table 3]**

| Pellets | | | R1 | R2 | R3 | R4 |
|---|---|---|---|---|---|---|
| Addition ratio (parts) | Resin (A) | A1 | 100 | 100 | 100 | 80 |
| | | A2 | | | | 20 |
| | Epoxy compound (B) | B1 | | 0.4 | | |
| | | B2 | | | | 4.5 |
| | Elastomer (C) | C1 | | | | 7.6 |
| | | C2 | | | | 7.6 |
| | | C3 | | | | 2.7 |
| | Flame retardant (D) | D1 | | | 21 | |
| | Antimony compound (E) | E1 | | | 11 | |
| | Reinforcement material (F) | F1 | 44 | 44 | 63 | 54 |
| | Polyolefin-based release agent (G) | G1 | | | 0.6 | 0.9 |
| | Stabilizer (H) | H1 | 0.3 | 0.3 | 0.3 | 0.6 |
| | Carbon black (I) | I1 | 2.9 | 2.9 | 2.9 | 2.9 |

### [Examples 1, 2, and 4]

Each of the molded resin articles shown in Table 3 was used, and a deposition apparatus capable of plasma treatment and sputtering treatment continuously using a hollow cathode electrode under a vacuum condition was used. The plasma CVD treatment and the sputtering treatment were performed in the vacuum atmosphere continuously without exposing the molded resin article under processing to the air, and a Cu film with a thickness of 200 nm or more was thereby formed. The plasma CVD conditions and the sputtering conditions are as follows.

### <Plasma CVD conditions>

The distance between the molded resin article and the hollow cathode electrode was set to 100 to 200 mm, and the preferred plasma CVD conditions described above were used.

The reaction gas used was an oxygen/argon gas mixture with an oxygen concentration of 99.9%.

### <Sputtering conditions>

Electric power: 10 to 40 kW
Pressure: 1.0 to 10 Pa

### [Examples 3 and 5]

A Cu film was formed in the same manner as in Example 2 or 4 except that, before the plasma CVD treatment, the molded resin article was subjected to heat treatment including heating the molded resin article at 120°C for 1 hour to 3 hours in air/N₂/a vacuum atmosphere (air pressure: atmospheric pressure, N₂: 133 Pa or lower, vacuum: 10⁻¹ Pa or lower) and, immediately after the heat treatment (within 0 to 30 minutes), the resulting molded resin article was subjected to the plasma CVD treatment.

### [Comparative Example 1]

A Cu film was formed in the same manner as in Example 1 except that the plasma CVD treatment was not performed and the molded resin article was directly subjected to the sputtering treatment.

### [Comparative Example 2]

A Cu film was formed in the same manner as in Example 1 except that R1 was used as the molded resin article.

### [Measurement of peel strength]

A Cu film with a thickness of 15 to 30 µm was formed on the metal film surface of each of the metal film-coated molded resin articles obtained in the Examples and Comparative Examples using electroplating treatment by a routine method, and the resulting article was used as a test piece.

The peel strength of the Cu film on each test piece obtained was measured according to an adhesion test method described in appendix 1 (specifications) of JIS H8630:2006 under the following conditions.
- Shape of test piece: flat plate of 100 mm × 100 mm × 3 mm thick
- Specimen adjustment: left to stand for 48 hours after plating
- Measurement apparatus: universal testing machine "TENSILON RTF2350" manufactured by A&D Company, Limited

The peel strength of each test piece is shown in Table 4.

**[Table 4]**

| | Example | | | | | Comparative Example | |
|---|---|---|---|---|---|---|---|
| | 1 | 2 | 3 | 4 | 5 | 1 | 2 |
| Molded resin article | R2 | R3 | R3 | R4 | R4 | R2 | R1 |
| Heat treatment | No | No | Yes | No | Yes | No | No |
| Plasma treatment | Yes | Yes | Yes | Yes | Yes | No | Yes |
| Peel strength (N/cm) | 9.31 | 9.48 | 10.00 | 13.04 | 15.83 | < 0.1 | 6.39 |

As can be seen from the results in Examples 1 to 5 and Comparative Example 1, when the plasma treatment is performed before film deposition by sputtering, a metal film with high adhesion can be formed.

In Comparative Example 2, although the plasma treatment was performed, the polybutylene terephthalate-based resin composition used did not contain the reactive component, and therefore the peel strength in the invention was not satisfied.

As can be seen by comparing Example 2 and Example 3 and comparing Example 4 and Example 5, when the heating treatment is performed before the plasma treatment, the adhesion of the metal film can be further increased. As can be seen by comparing Example 1 and Example 2, the adhesion of the metal film is higher in the molded resin article R3 containing the epoxy compound serving as the reactive component than in the molded resin article R2 not containing the epoxy compound.

In the molded resin article R4 containing the polyamide resin serving as the resin having reactive functional groups and an epoxy compound serving as the reactive compound, high adhesion could be obtained even though the plasma CVD treatment was performed for a short time.

Similarly, in the molded resin article R3 using the flame retardant having an epoxy group, high adhesion could be obtained.

Although the present invention has been described in detail by way of the specific modes, it is apparent for those skilled in the art that various changes can be made without departing from the spirit and scope of the present invention.

The present application is based on Japanese Patent Application No. 2018-169807 filed on September 11, 2018, the entire contents of which are incorporated herein by reference.

## Claims

1. A metal film-coated molded resin article comprising: a molded article formed of a polybutylene terephthalate-based resin composition and/or a polycarbonate-based resin composition; and a metal film disposed on a surface of the molded article, wherein the resin composition(s) contain(s) a reactive compound and/or a resin having a reactive functional group.

2. A metal film-coated molded resin article comprising: a molded article formed of a polybutylene terephthalate-based resin composition; and a metal film disposed on a surface of the molded article, wherein the peel strength of the metal film that is measured according to an adhesion test method described in appendix 1 (specifications) of JIS H8630:2006 is 9.0 N/cm or more.

3. The metal film-coated molded resin article according to claim 2, wherein the polybutylene terephthalate-based resin composition contains a reactive compound and/or a resin having a reactive functional group.

4. The metal film-coated molded resin article according to claim 1 or 3, wherein the reactive compound and/or the resin having the reactive functional group is a compound having an amido group and/or a resin containing an amido group.

5. The metal film-coated molded resin article according to claim 4, wherein the resin containing the amido group is a polyamide resin.

6. A plating film-coated molded article comprising: the metal film-coated molded resin article according to any of claims 1 to 5; and a plating layer disposed on the metal film.

7. A vehicle-mounted component comprising the plating film-coated molded article according to claim 6.

8. An electrical component comprising the plating film-coated molded article according to claim 6.

9. A resin composition used to produce a metal film-coated molded resin article including a metal film formed on a surface of a molded polybutylene terephthalate-based resin article and/or a surface of a molded polycarbonate-based resin article using a dry process, the resin composition comprising a reactive compound and/or a resin having a reactive functional group.

10. A method for producing the metal film-coated molded resin article according to any of claims 1 to 5, the method comprising depositing the metal film on a surface of a molded polybutylene terephthalate resin-based article and/or a surface of a molded polycarbonate-based resin article using a dry process.

11. The method for producing the metal film-coated molded resin article according to claim 10, wherein, after the surface of the molded polybutylene terephthalate resin-based article and/or the surface of the molded polycarbonate-based resin article is subjected to plasma treatment in a vacuum atmosphere, the metal film is deposited on the plasma-treated surface(s) by sputtering.

12. A method for producing a plating film-coated molded article, the method comprising forming a plating layer on the metal film of the metal film-coated molded resin article produced in claim 11.
